(19) Europäisches Patentamt / European Patent Office / Office européen des brevets

(11) **EP 3 433 876 B1**

(12) **EUROPÄISCHE PATENTSCHRIFT**

(45) Veröffentlichungstag und Bekanntmachung des Hinweises auf die Patenterteilung:
**13.09.2023 Patentblatt 2023/37**

(21) Anmeldenummer: **17713255.2**

(22) Anmeldetag: **23.03.2017**

(51) Internationale Patentklassifikation (IPC):
*H01L 21/304* (2006.01)   *C09J 183/02* (2006.01)
*H01L 21/56* (2006.01)   *H01L 21/02* (2006.01)
*C08K 3/08* (2006.01)

(52) Gemeinsame Patentklassifikation (CPC):
(C-Sets verfügbar)
**C08K 3/08; C08K 3/04; C08K 3/041; C08K 3/36;
C08K 7/02; H01L 21/304;** C08K 2003/0812;
C08K 2003/085; C08K 2003/0856; C08K 2003/0893

(Forts.)

(86) Internationale Anmeldenummer:
**PCT/EP2017/056945**

(87) Internationale Veröffentlichungsnummer:
**WO 2017/162800 (28.09.2017 Gazette 2017/39)**

(54) **EIN SPLITTING-VERFAHREN**

A SPLITTING METHOD

UN PROCÉDÉ DE DIVISION

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorität: **24.03.2016 DE 102016105616
07.12.2016 DE 102016123679**

(43) Veröffentlichungstag der Anmeldung:
**30.01.2019 Patentblatt 2019/05**

(73) Patentinhaber: **Siltectra GmbH
01099 Dresden (DE)**

(72) Erfinder:
• **BEYER, Christian
  09599 Freiberg (DE)**
• **RICHTER, Jan
  01277 Dresden (DE)**
• **SWOBODA, Marko
  01097 Dresden (DE)**

(74) Vertreter: **Westphal, Mussgnug & Partner,
Patentanwälte mbB
Werinherstraße 79
81541 München (DE)**

(56) Entgegenhaltungen:
EP-A1- 3 361 495      WO-A2-2010/072675
US-A- 5 611 884      US-A1- 2005 253 286
US-A1- 2011 028 647      US-A1- 2013 217 186

EP 3 433 876 B1

(52) Gemeinsame Patentklassifikation (CPC): (Forts.)

C-Sets
**C08K 3/04, C08L 83/04;**
**C08K 3/041, C08L 83/04;**
**C08K 3/08, C08L 83/04;**
**C08K 3/36, C08L 83/04;**
**C08K 7/02, C08L 83/04**

C-Sets

**Beschreibung**

Die Erfindung betrifft ein Splitting-Verfahren unter Nutzung eines Polymer-Hybrid-Materials.

Vor allem in der Mikroelektronik und Photovoltaik werden Wafer, d. h. dünne Scheiben oder Platten, aus Materialien wie Silizium, Germanium oder Saphir eingesetzt. Diese werden derzeit üblicherweise aus einem säulen- oder blockförmigen Festkörper, welcher auch als Ingot bezeichnet wird, gewonnen.

Aus derartigen Ingots werden beispielsweise mittels eines Säge- oder Zerreißverfahrens zylinder- oder scheibenförmige Teilstücke erzeugt. Diese Teilstücke können bereits einen Wafer repräsentieren oder die erhaltenen Teilstücke werden weiter unterteilt, bis diese die gewünschte Dicke eines herzustellenden Wafers aufweisen.

Bei dem Säge- oder Zerreißverfahren werden zumeist Draht- oder Diamantdrahtsägen eingesetzt, wodurch ein Teil von bis zu 50 % des ursprünglichen Festkörpers in Form von Spänen als sog. "kerf-loss" verloren geht, was insbesondere bei teuren Ausgangsmaterialien nachteilig ist.

Beispielsweise gehen mit den derzeit üblichen Verfahren allein bei der Herstellung von Siliziumwafern für Solarzellen fast 50 % des eingesetzten Materials als "kerf-loss" verloren. Weltweit gesehen entspricht dies einem jährlichen Verlust von über 2 Milliarden Euro. Da die Kosten des Wafers den größten Anteil an den Kosten der fertigen Solarzelle ausmachen (über 40 %), könnten durch entsprechende Verbesserungen der Waferherstellung die Kosten von Solarzellen signifikant reduziert werden.

Zudem verursacht der Sägevorgang häufig eine Schädigung der Waferoberfläche, welche mittels zusätzlicher Prozessschritte zur Oberflächenbehandlung, wie beispielsweise Läpp- oder Polierverfahrensschritten, beseitigt werden muss.

Besonders attraktiv für eine solche Waferherstellung ohne kerf-loss ("kerf-free wafering") erscheinen Verfahren, die auf das herkömmliche Sägen verzichten und z. B. durch Einsatz von temperaturinduzierten Spannungen direkt dünne Wafer von einem dickeren Werkstück abspalten können. Dazu gehören insbesondere Verfahren, wie sie z. B. in WO 2009/061353 A2 und WO 2010/072675 A2 beschrieben sind, wo zum Erzeugen dieser Spannungen eine auf das Werkstück aufgetragene Polymerschicht verwendet wird.

Die Polymerschicht weist bei den erwähnten Verfahren einen im Vergleich zum Werkstück um ungefähr zwei Größenordnungen höheren thermischen Ausdehnungskoeffizienten auf. Außerdem kann durch Ausnutzen eines Glasübergangs ein relativ hoher Elastizitätsmodul in der Polymerschicht erreicht werden, so dass im Schichtsystem Polymerschicht-Werkstück durch Abkühlen genügend große Spannungen induziert werden können, um die Abspaltung von Wafer vom Werkstück zu ermöglichen. Ein solches Verfahren wird nachfolgend als "Splitting-Verfahren" bezeichnet.

Beim Abspalten eines Wafers vom Werkstück haftet bei den erwähnten Verfahren jeweils auf einer Seite des Wafers noch Polymer an. Der Wafer krümmt sich dabei sehr stark in Richtung dieser Polymerschicht, was ein kontrolliertes Abspalten erschwert, und z. B. zu Dickenschwankungen des abgespaltenen Wafers führen kann. Außerdem erschwert die starke Krümmung die weitere Verarbeitung und kann sogar zum Zerbrechen des Wafers führen.

Bei Verwendung der Verfahren nach bisherigem Stand der Technik weisen die hergestellten Wafer üblicherweise jeweils größere Dickenschwankungen auf, wobei die räumliche Dickenverteilung häufig ein Muster mit vielzähliger Symmetrie zeigt. Die totale Dickenschwankung über den ganzen Wafer gesehen ("total thickness variation", TTV) beträgt bei Verwendung der bisherigen Verfahren häufig mehr als 100 % der mittleren Waferdicke (ein Wafer von bspw. 100 $\mu$m mittlerer Dicke, der z. B. an seiner dünnsten Stelle 50 $\mu$m dick und an seiner dicksten Stelle 170 $\mu$m dick ist, hat ein TTV von 170-50=120 $\mu$m, was relativ zu seiner mittleren Dicke einer totalen Dickenschwankung von 120 % entspricht).

Wafer mit solch starken Dickenschwankungen sind für viele Anwendungen nicht geeignet. Außerdem liegen bei den am häufigsten auftretenden vierzähligen Dickenverteilungsmustern die Bereiche mit den größten Schwankungen unglücklicherweise in der Mitte des Wafers, wo sie am meisten stören.

Außerdem entstehen beim Verfahren nach aktuellem Stand der Technik während der Bruchpropagation beim Abspalten selbst unerwünschte Oszillationen in den beteiligten Schichtsystemen, die den Verlauf der Bruchfront ungünstig beeinflussen und insbesondere zu signifikanten Dickenschwankungen des abgespaltenen Wafers führen können.

Weiterhin ist aus der DE 10 2012 001 620 A1 ein Verfahren bekannt, bei welchem zur Herstellung von Wafern auf den Festkörper eine Polymerfolie mittels Kleber aufgebracht wird. Nach dem Aushärten des Klebers wird der Festkörper zusammen mit der Polymerfolie thermisch gestresst. Durch unterschiedliche thermische Eigenschaften von Festkörper und Polymer bricht der Festkörper in zwei dünnere Teilstücke.

Auf einem der beiden Teilstücke haftet nunmehr einseitig noch die Polymerfolie, welche in einem nachfolgenden Schritt von der Oberfläche entfernt werden muss.

Das beschriebene Verfahren kann auch zur Teilung eines dicken Wafers in zwei dünne Wafer genutzt werden, indem auf beide gegenüberliegende Seiten des dicken Wafers Polymerfolien aufgeklebt werden und dieser durch eine entsprechende thermische Behandlung in zwei dünne Wafer aufgespalten wird.

Die Effektivität eines solchen Verfahrens ist insbesondere von der Auswahl eines Polymers mit einer geeigneten Glasübergangstemperatur ($T_g$), der Temperaturleitfähigkeit des Polymers sowie dessen mechanischen Eigenschaften wie Sprödigkeit, Zugfestigkeit und Elastizität abhängig.

Weiterhin ist in der DE 10 2012 001 620 A1 die Verwendung einer zusätzlichen Opferschicht zwischen Festkörper und Polymerfolie beschrieben, welche der verbesserten Entfernung der Polymerfolie nach dem Abspaltungsschritt dient, indem die Opferschicht beispielsweise chemisch durch Zugabe geeigneter Reaktanten zersetzt oder abgelöst wird.

Nachteilig an diesem Verfahren ist jedoch die lange Zeitdauer, welche bis zu mehreren Stunden bestragen kann, die bis zu einer vollständigen Entfernung der Polymerschicht vergeht. Dies schränkt eine industrielle Nutzung stark ein.

Zur Beschleunigung des Prozesses der Polymerentfernung besteht die Möglichkeit, durch eine entsprechende Vorbehandlung zusätzliche Triebkräfte in Form von geeigneten, auch bei Raumtemperatur wirkenden Zugspannungen einzubringen. Diese führen zu einer Vergrößerung der Angriffsfläche für die Reaktanten oder das Lösungsmittel und begünstigen das Zersetzen oder das Ab- und Auflösen.

Durch die eingebrachten zusätzlichen Spannungen kann es jedoch auch nach der Entfernung des Polymers zu einer Beschädigung des gespaltenen Festkörpers, also z. B. des Wafers, kommen, indem dieser beispielsweise bricht. Damit verbunden ist eine Verschlechterung der Gesamtausbeute, welche den Kostenvorteil des Splitting-Verfahrens verringert.

Weiterhin ist aus der WO 2010/072675 A2 bekannt, Füllstoffe im Polymer vorzusehen, um den thermischen Ausdehnungskoeffizienten oder den Elastizitätsmodul lokal beeinflussen zu können.

Allerdings wurde festgestellt, dass derartige Füllstoffe oftmals die Haftung des Polymers auf der Oberfläche des zu teilenden Festkörpers verschlechtern, so dass keine ausreichende Kraftübertragung mehr möglich ist.

Zudem wird nach dem Stand der Technik aufgrund der schlechten thermischen Leitfähigkeit des Polymers eine lange Abkühldauer benötigt, um die notwendigen Spannungen induzieren zu können.

Außerdem ist es bei den bisherigen Verfahren schwierig, einen reproduzierbar guten Wärmekontakt über die ganze Fläche der Polymerschicht sicherzustellen. Lokal ungenügender Wärmekontakt kann aber aufgrund der geringen thermischen Leitfähigkeit der verwendeten Polymere zu ungewollten, signifikanten lokalen Temperaturabweichungen im Schichtsystem führen, was sich seinerseits negativ auf die Kontrollierbarkeit der erzeugten Spannungsfelder und damit die Qualität der hergestellten Wafer auswirkt.

Weiterhin ist aus der Druckschrift DE 196 40 594 A1 ein Verfahren zur Trennung von Halbleitermaterialien mittels lichtinduzierter Grenzflächenzersetzung und damit hergestellter Vorrichtungen, wie strukturierte und freistehende Halbleiterschichten und Bauelemente, bekannt.

Das Verfahren gemäß der DE 196 40 594 A1 beinhaltet die Beleuchtung von Grenzflächen zwischen Substrat und Halbleiterschicht oder zwischen Halbleiterschichten, wodurch die Lichtabsorption an der Grenzfläche oder in einer dafür vorgesehenen Absorptionsschicht zur Materialzersetzung führt. Die Auswahl der Grenzfläche oder Halbleiterschicht, welche zur Zersetzung gebracht wird, erfolgt durch die Wahl der Lichtwellenlänge und Lichtintensität, die Einstrahlrichtung oder den Einbau einer dünnen Opferschicht während der Materialherstellung.

Dieses Verfahren hat den Nachteil, dass zur Zerstörung ganzer Schichten hohe Energiedosen verwendet werden müssen, wodurch der Energiebedarf und somit die Kosten des Verfahrens sehr hoch sind.

Die EP 3 361 495 A1 offenbart ein Splitting-Verfahren unter Verwendung eines Polymer-Hybrid-Materials. Das Polymer-Hybrid-Material enthält eine Polymermatrix, die eine Elastomermatrix ist und einen oder mehrere Füllstoffe enthält. Das Splitting-Verfahren umfasst die Schritte des Bereitstellens des Festkörper-Ausgangsmaterials mit zumindest einer frei liegenden Oberfläche, des Aufbringens des Polymer-Hybrid-Materials auf zumindest eine freiliegende Oberfläche des Festkörper-Ausgangsmaterial, so dass eine Verbundstruktur resultiert und die Beaufschlagung der Verbundstruktur mit einem Spannungsfeld derart, dass das Festkörper-Ausgangsmaterial entlang einer Ebene innerhalb des Festkörper-Ausgangsmaterials in zumindest zwei Festkörper-Teilstücke gespalten wird. Einer der Füllstoffe besteht aus zumindest einem Metall und bewirkt eine verbesserte Wärmeleitfähigkeit innerhalb des Polymer-Hybrid-Materials.

Aufgabe der vorliegenden Erfindung ist es, eine Möglichkeit zur Erhöhung der Gesamtausbeute, d. h. der Effizienz in Bezug auf die eingesetzten Rohmaterialien und die anderweitigen Ressourcen wie Energie und Arbeitskraft, eines Splitting-Verfahrens anzugeben.

Insbesondere sollen die Abkühldauer und der zeitliche Verlauf der Polymerentfernung nach der Teilung des Festkörpers gezielt beeinflusst werden.

Bevorzugt soll das Polymer schnell, rückstandsfrei und ohne Beschädigung des geteilten Ausgangsmaterials von diesem abtrennbar sein.

Zudem soll die Prozessstabilität durch eine Minimierung der Anzahl an Verfahrensschritten erhöht werden.

Die erfindungsgemäße Lösung dieser Aufgabe erfolgt durch ein Splitting-Verfahren gemäß Anspruch 1, bei dem ein Polymer-Hybrid-Material verwendet wird. Anspruch 15 betrifft die Verwendung des Polymer-Hybrid-Materials in einem Splitting-Verfahren.

Untersuchungen zeigen, dass es sich bei der Entfernung der Polymerschicht durch Zersetzung, Ab- oder Auflösung um eine diffusionskontrollierte Reaktion der beteiligten Reaktanten und Lösungsmittel handelt. Mit fortschreitendem Zeitverlauf wird der Zu- und Abtransport der Reaktanten im sich ausbildenden Spalt zwischen Festkörper und Polymer immer mehr erschwert und sehr stark verlangsamt. Somit ist der An- und Abtransport der Reaktionsprodukte und -edukte und des Lösungsmittels sowie der gelösten Bestandteile der diffusionskontrollierte geschwindigkeitsbestimmende Schritt.

Erfindungsgemäß wird daher ein Polymer-Hybrid-Material zur Verwendung in einem Splitting-Verfahren angegeben, bei welchem aus einem Festkörper-Ausgangsmaterial zumindest zwei Festkörper-Teilstücke erzeugt werden.

Das erfindungsgemäße Polymer-Hybrid-Material umfasst eine Polymermatrix, einen darin eingebetteten ersten Füllstoff, der ein Metall umfasst oder aus einem Metall besteht, und einen zweiten Füllstoff, der Kern-Schale-Polymerpartikel umfasst. Das Polymer-Hybrid-Material ist als solches nicht vom Umfang der Ansprüche umfasst.

Als Polymermatrix kann jedes Polymer oder eine Mischung verschiedener Polymere genutzt werden, mit dessen Hilfe sich die für eine Teilung des Festkörper-Ausgangsmaterials notwendigen Spannungen erzeugen lassen. Beispielsweise kann die Polymermatrix als Elastomermatrix, bevorzugt als Polydiorganolsiloxan-Matrix, besonders bevorzugt als Polydimethylsiloxan-Matrix, ausgebildet sein.

Derartige Polymermaterialien lassen sich besonders einfach als Matrixmaterial in Kombination mit Füllstoffen nutzen, da die Eigenschaften aufgrund des variierbaren Vernetzungsgrads flexibel eingestellt und an den jeweiligen Füllstoff sowie das zu teilende Festkörper-Ausgangsmaterial angepasst werden können.

Gemäß einer Ausführungsvariante beträgt der Masseanteil der Polymermatrix am Polymer-Hybrid-Material 80 % bis 99 %, bevorzugt 90 % bis 99 %.

Der erste Füllstoff ist derart aufgebaut, dass er als Reaktant, Initiator, Katalysator oder Promotor während des Ablösens des Polymer-Hybrid-Materials vom Festkörper-Teilstück nach der Teilung wirkt und dadurch im Vergleich zu einem Polymermaterial ohne ersten Füllstoff zu einem schnelleren Ablösen des Polymer-Hybrid-Materials vom Festkörper-Teilstück nach der Teilung führt.

Die konkrete chemische Zusammensetzung und Ausgestaltung des ersten Füllstoffs sowie dessen Masseanteil ist dabei insbesondere abhängig vom konkreten Material der Polymermatrix, welche abgelöst werden soll, dem dafür genutzten Lösungsmittel und den verwendeten Reaktanten. Weiterhin spielen auch das Material des Festkörper-Ausgangsmaterials und die Dimensionen des zu teilenden Festkörper-Ausgangsmaterials eine Rolle.

Der konkrete Anteil des ersten Füllstoffs in der Polymermatrix ist stark vom Material des Füllstoffs und dessen Wirkungsweise abhängig. Zum einen muss die Polymermatrix trotz Füllstoff ihrer Aufgabe der Erzeugung von Spannungen noch gerecht werden können. Zum anderen muss der Anteil des ersten Füllstoffs hoch genug sein, um die angestrebte Beeinflussung der Polymerentfernung zu erreichen. Den jeweils optimalen Masseanteil des ersten Füllstoffs kann der Fachmann im Rahmen einfacher konzentrationsabhängig durchgeführter Versuche ermitteln.

Zur Verbesserung der mechanischen Eigenschaften kann zusätzlich ein weiterer Füllstoff, wie z. B. pyrogene Kieselsäure in Form eines anorganischen Netzwerkes im Polymer beitragen. Neben diesen starken Wechselwirkungen in Form des Netzwerks können auch weniger starke Interaktionen durch rein hydrodynamische Verstärkungen zur Verbesserung beitragen.

Beispielhaft ist hier eine gezielte Steigerung der Viskosität zu nennen, die eine verbesserte Verarbeitung im Splitting-Verfahren ermöglicht und so zu verbesserten Fertigungstoleranzen beitragen kann. Weiterhin wird durch diese Wechselwirkung eine Verringerung der inneren Freiheitsgrade hinsichtlich einer strukturellen Umorientierung mit zunehmender Bewehrung erschwert.

Dies führt zu einer gewünschten Erniedrigung der Glasübergangstemperatur des eingesetzten Polymers im Polymer-Hybrid-Material, was den Vorteil einer geringeren Temperatur im Splitting-Verfahren ermöglicht.

Erfindungsgemäß wird der erste Füllstoff in einem Polymer-Hybrid-Material zur Beschleunigung des Ablösens des Polymer-Hybrid-Materials von einem Festkörper-Teilstück, das durch Teilung mittels eines Splittingverfahrens, bei dem ein Festkörper-Ausgangsmaterial in zumindest zwei Festkörper-Teilstücke geteilt wird, erhalten wird, verwendet.

Der erste Füllstoff kann in der Polymermatrix derart verteilt sein, dass der Masseanteil des ersten Füllstoffs ausgehend von der äußeren, d. h. unteren, Grenzfläche des Polymer-Hybrid-Materials, die während des Splitting-Verfahrens mit dem Festkörper-Ausgangsmaterial verbunden ist, in Richtung einer parallel zur unteren Grenzfläche angeordneten weiteren Grenzfläche des Polymer-Hybrid-Materials, abnimmt. Dies bedeutet, dass der Masseanteil des Füllstoffs nahe beim Festkörper-Ausgangsmaterial bzw. Teilstück größer ist als in den übrigen Bereichen des Polymer-Hybrid-Materials.

Diese Verteilung des ersten Füllstoffs ermöglicht eine besonders effektive Entfernung des Polymer-Hybrid-Materials nach der Trennung, da sich der der erste Füllstoff nahe an der Grenzfläche zum Festkörper-Teilstück befindet und dort seine Wirkung entfalten kann. Gleichzeitig weisen die restlichen Bereiche des Polymer-Hybrid-Materials weniger oder gar keine Anteile des ersten Füllstoffs auf, so dass die Funktion des Polymers möglichst wenig beeinflusst wird.

In einer Ausgestaltung ist das Polymer-Hybrid-Material schichtförmig aufgebaut, wobei lediglich eine dem Festkörper-Ausgangsmaterial zugewandte Schicht den ersten Füllstoff aufweist, während das restliche Polymer-Hybrid-Material frei vom ersten Füllstoff ist.

Weiterhin kann ein unterer Bereich des Polymer-Hybrid-Materials, der direkt an dessen untere Grenzfläche angrenzt frei von dem ersten Füllstoff sein. Damit kann sich eine Bereichsabfolge wie folgt ergeben: Benachbart zum Festkörper-Ausgangsmaterial befindet sich zunächst ein Bereich ohne ersten Füllstoff, darauf folgt ein Bereich mit einem hohen Anteil an erstem Füllstoff und danach ein Bereich mit niedrigem Anteil an erstem Füllstoff oder ohne ersten Füllstoff.

Diese und alle im Folgenden beschriebenen Bereiche können in Form von Schichten ausgebildet sein, d. h. der Bereich erstreckt sich überwiegend parallel zu der Grenzfläche des Festkörper-Ausgangsmaterials, auf die das Polymer-Hybrid-Material aufgebracht wird und weist eine Längs- und Querausdehnung zumindest im Bereich dieser Grenzfläche auf.

Ein unterer Bereich ohne ersten Füllstoff kann insbesondere für den Fall vorgesehen werden, dass der erste Füllstoff die Haftung des Polymer-Hybrid-Materials auf dem Festkörper-Ausgangsmaterial verschlechtert. Um dies zu vermeiden, wird zunächst ein Bereich ohne ersten Füllstoff angeordnet, auf den ein Bereich mit einem hohen Anteil an erstem Füllstoff folgt, damit der erste Füllstoff seine Funktion erfüllen kann. Eine untere Schicht ohne ersten Füllstoff kann beispielsweise eine Dicke zwischen 10 $\mu$m und 500 $\mu$m, beispielsweise 100 $\mu$m, aufweisen.

Weiterhin kann ein oberer Bereich des Polymer-Hybrid-Materials, der direkt an dessen obere Grenzfläche angrenzt frei von dem ersten Füllstoff sein. Unter der oberen Grenzfläche ist dabei die Grenzfläche zu verstehen, die das Polymer-Hybrid-Material gegenüberliegend zur unteren Grenzfläche und zum Festkörper-Ausgangsmaterial zur Umgebung hin begrenzt. Untere und obere Grenzfläche können parallel zueinander angeordnet sein.

Ein solcher oberer Bereich ohne ersten Füllstoff kann insbesondere dann vorgesehen werden, wenn der erste Füllstoff die Wärmeübertragung zwischen Umgebung und Polymer-Hybrid-Material nachteilig beeinflusst, beispielsweise wenn die Abkühlung des Polymer-Hybrid-Materials verzögert werden würde.

Der erste Füllstoff umfasst ein Material oder besteht aus einem Material, das mit einem Reaktionsmittel, bevorzugt einem Oxidationsmittel unter Freisetzung eines gasförmigen Produkts reagieren kann.

Dadurch sind in der Polymermatrix Kavitäten generierbar, die einen schnelleren Zugang der Reaktanten und Lösungsmittel zur Polymermatrix und einer etwaige vorhandenen Opferschicht ermöglichen und zudem einen schnelleren Abtransport der Edukte und gelösten Bestandteile bewirken.

Durch die Generierung gasförmiger Reaktionsprodukte können zusätzliche Triebkräfte eingebracht werden, die die Entfernung des Polymer-Hybrid-Materials weiter unterstützen.

Die Ausbildung zusätzlicher Kavitäten sowie das Entstehen gasförmiger Reaktionsprodukte beschleunigt die Polymerentfernung und trägt daher zu einer Erhöhung der Gesamtausbeute des Splitting-Verfahrens bei. Durch Variation des Anteils an erstem Füllstoff kann die Kavitätendichte im Grenzbereich zwischen Festkörper-Teilstück und Polymer-Hybrid-Material bzw. zwischen Opferschicht und Polymer-Hybrid-Material gezielt beeinflusst werden.

Wie oben ausgeführt umfasst der erste Füllstoff ein Metall, insbesondere Aluminium, Eisen, Zink und/oder Kupfer oder besteht der erste Füllstoff aus einem Metall, insbesondere den zuvor genannten Metallen.

"Bestehend aus" schließt auf alle vorliegend genannten Materialien bezogen ein, dass technologisch bedingte Verunreinigungen oder technologisch bedingte Beimengungen, die z. B. der Herstellung der Füllstoffe sowie deren Verteilung oder Anbindung an die Polymermatrix dienlich sind, enthalten sein können.

Metallische Füllstoffe können mit Oxidationsmitteln wie z. B. Salzsäure, Salpetersäure, Zitronensäure, Ameisensäure oder Sulfaminsäure unter Freisetzung eines gasförmigen Produkts reagieren und dadurch aus dem Polymer-Hybrid-Material entfernt werden.

Beispielsweise reagiert Aluminium mit konzentrierter Salzsäure unter Ausbildung von solvatisierten Metallionen und Wasserstoff gemäß folgender Gleichung:

$$6 \text{ HCl} + 2 \text{ Al} + 12 \text{ H}_2\text{O} \rightarrow 2 \text{ [AlCl}_3\text{*6 H}_2\text{O]} + 3 \text{ H}_2$$

In ähnlicher Weise führt die Reaktion von Zink als Füllstoff durch Reaktion mit konzentrierter Salzsäure zur Bildung zusätzlicher Kavitäten:

$$\text{Zn} + 2 \text{ HCl} \rightarrow \text{ZnCl}_2 + \text{H}_2$$

In den genannten Beispielen werden durch die Generierung von Wasserstoff zusätzliche Triebkräfte eingebracht, die die Entfernung des Polymer-Hybrid-Materials weiter unterstützen.

Zudem kann der erste Füllstoff die Temperaturleitfähigkeit innerhalb des Polymer-Hybrid-Materials verbessern, beispielsweise, indem der erste Füllstoff eine höhere Temperaturleitfähigkeit als das Polymer der Polymermatrix aufweist. Dies kann beispielsweise der Fall sein, wenn der erste Füllstoff ein Metall umfasst. Durch eine verbesserte Temperaturleitfähigkeit können die für die Teilung des Festkörper-Ausgangsmaterials mittels Abkühlung erzeugten Spannungen effektiver, d. h. schneller und unter geringerem Verbrauch an Kühlmittel, generierbar sein. Dies kann die Gesamtausbeute des Splitting-Verfahrens erhöhen.

Weiterhin ist erfindungsgemäß im Polymer-Hybrid-Material ein zweiter Füllstoff vorgesehen sein, der die Haftung des Polymer-Hybrid-Materials auf dem Festkörper-Ausgangsmaterial im Vergleich zu einem Polymer-Hybrid-Material ohne zweiten Füllstoff erhöht. Bevorzugt wird die Haftung im Vergleich zu einem Polymermaterial ohne Füllstoff erhöht.

Beispielsweise kann es sich bei dem zweiten Füllstoff um einen Füllstoff handeln, der mittels Plasma aktiviert werden kann. Durch die Plasmaaktivierung resultieren neue Oberflächenspezies, die so geschaffen werden können, dass eine stärkere Wechselwirkung mit der Oberfläche des Festkörper-Ausgangsmaterials resultiert und im Ergebnis die Haftung des Polymer-Hybrid-Materials verbessert wird.

Die Art der durch die Plasmabehandlung erzielbaren Oberflächenspezies ist dabei vorrangig von der Prozessführung des Plasmaprozesses abhängig. Beispielsweise können während der Plasmabehandlung Gase wie Stickstoff, Sauerstoff, Silane oder Chlorsilane zugefügt werden, so dass beispielsweise polare Gruppen entstehen, welche stärker mit der Oberfläche des Festkörper-Ausgangsmaterials wechselwirken können.

Der zweite Füllstoff kann in der Polymermatrix so verteilt sein, dass der Masseanteil des zweiten Füllstoffs in Richtung der unteren Grenzfläche zunimmt. Beispielsweise kann das Polymer-Hybrid-Material den zweiten Füllstoff lediglich in einem Bereich angrenzend an die untere Grenzfläche enthalten, wobei der Bereich auch als Schicht im Sinne der oben genannten Definition ausgebildet sein kann.

Dies ermöglicht die Anordnung des zweiten Füllstoffs bevorzugt in der Nähe der Grenzfläche zwischen Polymer-Hybrid-Material und Festkörper-Ausgangsmaterial, wodurch die Haftung verbessert und damit eine größere Kraftübertragung in das zu teilende Festkörper-Ausgangsmaterial ermöglicht wird. Der zweite Füllstoff umfasst Kern-Schale-Polymerpartikel bzw. Core-Shell-Polymerpartikel. Dabei sind Partikel bevorzugt, deren Polymerzusammensetzung sich von der Polymermatrix des Polymer-Hybrid-Materials dahingehend unterscheidet, dass insbesondere die Oberfläche, d. h. die Schale, der Kern-Schale-Partikel stärker aktivierbar ist, z. B. mittels Niedertemperaturplasmas. Beispiele hierfür sind Kern-Schale-Partikel umfassend einen Polysiloxan-Kern mit einer Acrylat-Schale oder umfassend einen nanoskaligen Silikat-Kern mit einer Epoxid-Schale oder umfassend einen Kautschukpartikel-Kern mit eines Epoxid-Schale oder umfassend einen Nitrilkautschukpartikel-Kern mit einer Epoxid-Schale.

Der zweite Füllstoff ist mittels Niedertemperaturplasma, z. B. Kaltplasma, aktivierbar.

Beispielsweise kann das Plasma mittels dielektrischer Barriereentladung (DBE) erzeugt werden. Hierbei können Elektronendichten im Bereich von $10^{14}$ bis $10^{16}$ m$^{-3}$ erzeugt werden. Die durchschnittliche Temperatur des durch DBE erzeugten "kalten" Nichtgleichgewichtsplasmas (Plasmavolumen) beträgt ca. 300 ± 40 K bei Umgebungsdruck.

Bei der DBE-Behandlung wird die Oberfläche beispielsweise mit uni- oder bipolaren Pulsen von Pulsdauern von wenigen Mikrosekunden bis zu einigen zehn Nanosekunden und Amplituden im einstelligen bis zweistelligen Kilovoltbereich beaufschlagt. Hierbei sind keine metallischen Elektroden im Entladungsraum und somit keine metallischen Verunreinigungen oder Elektrodenverschleiß zu erwarten.

Vorteilhaft ist zudem eine hohe Effizienz, da an den Elektroden keine Ladungsträger aus- oder eintreten müssen. Dielektrische Oberflächen können bei niedrigen Temperaturen modifiziert und chemisch aktiviert werden. Die Oberflächenmodifikation kann beispielsweise durch eine Wechselwirkung und Reaktion der Oberflächenspezies durch Ionenbombardement erfolgen.

Weiterhin können gezielt Prozessgase, wie z. B. Stickstoff, Sauerstoff, Wasserstoff, Silane oder Chlorsilane, z. B. $Si_xH_yE_z$ mit E = F, Cl, Br, I, O, H und x = 0 bis 10, z = 0 bis 10, $SiH_4$, $Si(EtO)_4$ oder $Me_3SiOSiMe_3$, bei einer Plasmabehandlung zugefügt werden, um beispielsweise bestimmte chemische Gruppen an der Oberfläche zu erzeugen.

Der zweite Füllstoff kann des Weiteren mittels KoronaBehandlung, Flammenbehandlung, Fluorierung, Ozonierung oder UV-Behandlung bzw. Eximer-Bestrahlung aktivierbar sein.

Durch eine derartige Aktivierung werden beispielsweise polare Gruppen an der Oberfläche des zweiten Füllstoffs generiert, die mit der Oberfläche des Festkörper-Ausgangsmaterials wechselwirken können und so die Haftung verbessern.

Das Polymer-Hybrid-Material kann weiterhin zusätzlich im Vergleich zu einem Polymer-Hybrid-Material mit einem ersten oder zu einem Polymer-Hybrid-Material mit einem ersten und einem zweiten Füllstoff einen dritten Füllstoff umfassen.

Dieser dritte Füllstoff weist im Vergleich zu dem Polymer der Polymermatrix eine höhere Temperaturleitfähigkeit und/oder einen höheren Elastizitätsmodul auf.

Beispielsweise liegt der E-Modul des Polymers bei Tieftemperaturbedingungen im unteren einstelligen Gigapascalbereich (ca. 1-3 GPa), während beispielsweise metallische Füllstoffe einen E-Modul im zweistelligen bis dreistelligen Gigapascalbereich aufweisen. Bei einem entsprechenden hohen Füllstoffanteil ist ein perkolierendes Füllstoffnetzwerk möglich, was eine verbesserte "Krafteinkopplung" in das Festkörper-Ausgangsmaterial ermöglicht.

Die Perkolation wird wesentlich durch den Volumenfüllgrad der jeweiligen Füllstoffe beeinflusst (z. B. 0,1 Vol%, 1 Vol% bis 10 Vol% je nach Aspektverhältnis). Mit zunehmender Krafteinleitung kann der viskoelastische Schichtaufbau der Polymerstruktur eingetaucht werden und mehrere Perkolationspfade wirksam werden. Hier können verbesserte Wärmeübergänge ermöglicht werden, da es zu einem verbesserten Kontakt der Füllstoffe mit der Oberfläche des Festkörper-Ausgangsmaterials kommen kann.

Die mechanische Stabilität des Polymer-Hybrid-Materials wird auch bei tiefen Temperaturen schneller erreicht. In Summe kommt es zu einer geringeren Standardabweichung der entsprechenden Struktur-Eigenschaftsprofile wie z.

B. Bruchspannung und Bruchdehnung des Polymer-Hybrid-Materials und somit zu einer Erhöhung der Gesamtausbeute des Splitting-Verfahrens. Die ortsaufgelösten Eigenschafts-profiländerungen (Spannungsspitzen im Polymer-Hybrid-Material) und somit im Festkörper sind kleiner, was zu einer höheren Gesamtausbeute des Splitting-Verfahrens und einer besseren Qualität der erzeugten Festkörper-Teilstücke führt.

Der dritte Füllstoff kann einen verbesserten Wärmeübergang zwischen Umgebung und Polymer-Hybrid-Material und eine schnellere Wärmeleitung innerhalb des Polymer-Hybrid-Materials bewirken, sodass das Polymer-Hybrid-Material schneller abgekühlt werden kann und das Splitting-Verfahren insgesamt schneller und damit effektiver durchgeführt werden kann.

Durch eine Erhöhung des Elastizitätsmoduls lassen sich höhere Spannungen für die Teilung des Festkörper-Ausgangsmaterials erzeugen, so dass auch Festkörper-Ausgangsmaterialien geteilt werden können, für die eine besonders hohe Spannung benötigt wird.

Zudem kann der dritte Füllstoff auch der Beeinflussung des thermischen Ausdehnungskoeffizienten dienen. Ziel ist dabei ein möglichst großer Unterschied zwischen den Wärmeausdehnungskoeffizienten des Polymer-Hybrid-Materials und des zu teilenden Festkörper-Ausgangsmaterials, um zusätzliche, für die Teilung notwendige Spannungen erzeugen zu können. Bevorzugt weist der dritte Füllstoff einen hohen thermischen Ausdehnungskoeffizienten, d. h. einen Ausdehnungskoeffizienten, der höher als derjenige der Polymermatrix ist, auf. Beispielsweise kann der thermische Ausdehnungskoeffizient des dritten Füllstoffs mehr als 300 ppm/K betragen.

Der dritte Füllstoff kann so in der Polymermatrix verteilt sein, dass der Masseanteil des dritten Füllstoffs in Richtung der oberen Grenzfläche zunimmt, um einen schnelleren Wärmeübergang insbesondere an der Grenzfläche zur Umgebung zu ermöglichen.

Der dritte Füllstoff kann ein Metall, insbesondere Aluminium, Eisen, Zink und/oder Kupfer, umfassen oder aus einem der genannten Metalle bestehen. Metalle zeichnen sich im Allgemeinen durch eine hohe Wärmeleitfähigkeit und Temperaturleitfähigkeit aus.

Die beschriebenen Füllstoffe (erster, zweiter, dritter Füllstoff) können in partikulärer Form in der Polymermatrix verteilt vorliegen, wobei die Partikelgröße im μm- und nm-Bereich, bezogen auf zumindest eine Dimension des Partikels, liegen kann. Neben einer kugelförmigen Gestalt können die Füllstoffpartikel auch andere Ausgestaltungen, beispielsweise eine stäbchenförmige oder scheibenförmige Gestalt annehmen.

Die Füllstoffpartikel können sämtliche Partikelgrößenverteilungen aufweisen, beispielsweise monomodal oder bimodal, eng, insbesondere monodispers, oder breit. Die Füllstoffe können an die Polymermatrix sowohl physikalisch, z. B. durch Einbettung in das Polymernetzwerk, als auch chemisch angebunden sein.

Weiterhin können einer oder mehrere der beschriebenen weiteren Füllstoffe anorganische oder organische Fasern, beispielsweise Kohle-, Glas-, Basalt- oder Aramidfasern, umfassen oder aus solchen bestehen, sofern die zuvor beschriebenen Funktionen damit vereinbar sind. Optional kann auch ein weiterer Füllstoff hinzugefügt werden, der die genannten Fasern umfasst oder aus solchen besteht.

Fasern weisen üblicherweise stark anisotrope Eigenschaften auf. Durch eine richtungsabhängige Positionierung des Füllstoffs im Polymer-Hybrid-Material besteht die Möglichkeit einer gezielten Beeinflussung der für die Teilung des Festkörper-Ausgangsmaterials notwendigen Spannungen. Dies kann zur Erhöhung der Gesamtausbeute des Splitting-Verfahrens beitragen.

Ein zusätzlicher Vorteil besteht in dem Falle, dass ein organischer oder anorganischer Füllstoff als Faserstoff mit einer stark anisotropen Struktur eingesetzt wird, darin, dass dadurch eine Verbesserung der mechanischen Eigenschaften innerhalb des Polymer-Hybrid-Materials erreicht werden kann. Zusätzlich oder alternativ kann ein weiterer Füllstoff umfassend oder bestehend aus Kern-Schale-Partikeln im Polymer-Hybrid-Material vorgesehen sein.

Der Einsatz von Kern-Schale-Polymerpartikeln erlaubt zusätzlich neben einer verbesserten Aktivierbarkeit auch eine neue Gestaltung von energieabsorbierenden Mechanismen, die in Summe zu einer Schlagzähigkeits- und Bruchzähigkeitserhöhung, insbesondere einer Erhöhung der Tieftemperatur-Schlagzähigkeit, des Polymer-Hybrid-Materials beim Einsatz im Splitting-Verfahren führen können und somit ebenfalls zu einer höheren Gesamtausbeute des Splitting-Verfahrens beitragen können. Beispielsweise kann eine mechanische Zerstörung einer Folie aus einem Polymer-Hybrid-Material mit einer geringeren Wahrscheinlichkeit auftreten, so dass die Möglichkeit einer Wiederverwendung der Folie begünstigt werden kann.

Beispielhaft kann durch Unterbindung der Rissausbreitung aufgrund von Kern-Schale-Polymerpartikel eine Zerstörung der Folie beim Splitting-Verfahren verhindert werden und somit Wiederverwertungswege eröffnet werden.

Hierbei können enthaltene Elastomerpartikel eine plastische Deformation erfahren und Hohlräume bilden, wodurch weitere zusätzliche Energie aufgenommen werden kann. Ebenso ist eine zusätzliche Energieaufnahme durch das Scherfließen der Matrix kompensierbar, was insgesamt die mechanischen Eigenschaften verbessert.

Kern-Schale-Partikel zeichnen sich dadurch aus, dass ein in der Regel kugelförmiger Kern aus einem Material von einer Schale aus einem zweiten Material umgeben ist. Die Schale kann entweder den Kern komplett umhüllen oder aber auch durchlässig sein.

Bei den Materialien kann es sich sowohl um anorganische Materialien, wie z. B. Metalle, oder um organische Materialien, wie z. B. Polymere handeln. Beispielsweise können zwei verschiedene Metalle miteinander kombiniert werden. Es besteht aber auch die Möglichkeit, einen Kern aus einem Polymer mit einer Schale aus einem Metall oder einem zweiten Polymer zu umgeben.

Kern-Schale-Partikel ermöglichen die Kombination der Eigenschaften des ersten und zweiten Materials. Beispielsweise kann über einen preiswerten Polymerkern die Größe und Dichte der Füllstoffpartikel festgelegt werden, während die metallische Schale wie oben beschrieben reagieren kann. Aufgrund ihrer oftmals monodispersen Partikelgrößenverteilung lassen sich die Eigenschaften der Kern-Schale-Partikel zudem präzise vorhersagen und einstellen.

Darüber hinaus können ein oder mehrere weitere Füllstoffe Kohlenstoff in Form von Industrieruß (Carbon Black), Graphit, zerkleinerten Kohlenstofffasern (chopped carbon fiber), Kohlenstoffnanofasern (carbon nanofibers), bevorzugt in Form von Kohlenstoffnanoröhrchen (carbon nanotubes, CNT), wie z. B. mehrwandigen Kohlenstoffnanoröhrchen (multi-walled carbon nanotubes, MWCNT) sowie einwandigen Kohlenstoffnanoröhrchen (singlewalled carbon nanotubes, SWCNT), umfassen oder aus diesen bestehen.

Bei Kohlenstoffnanoröhrchen handelt es sich um zylinderförmige Graphitlagen, die aus einer unterschiedlichen Anzahl an Zylindern aufgebaut sind. Bestehen diese Röhrchen nur aus einem Zylinder, so werden sie als singlewalled carbon nanotubes (SWCNT) bezeichnet. Sind zwei oder mehr Zylinder vorhanden, entstehen entweder double-walled (DWCNT) oder die multi-walled carbon nanotubes (MWCNT). Diese können vorzugsweise konzentrisch ineinander geschachtelt vorliegen.

Gemäß verschiedenen Ausführungsvarianten kann der dritte Füllstoff MWCNTs umfassen oder aus diesen bestehen, da diese eine besonders hohe Wärmeleitfähigkeit (> 3000 W*(m*K)$^{-1}$) besitzen und gleichzeitig eine sehr hohe Reißfestigkeit im Bereich von 5-60 GPa aufweisen. Die hohe mechanische Stabilität zeigt sich dabei in hohen Reißwerten, extremer Elastizität und einer sehr guten Strapazierfähigkeit des Füllstoffs.

Grundlage hierfür sind die sp$^2$ hybridisierten starken $\sigma$-C-C-Bindungen verbunden mit einem delokalisierten p-Orbital als $\pi$-Bindung zu drei benachbarten Kohlenstoffatomen. Hierbei sind Verbiegungen bis zu 90° möglich.

Mit SWCNT sind noch höhere Eigenschaftswerte erreichbar (E-Modul: 410 GPa bis 4150 GPa vs. Graphit: 1000 GPa, SWCNT: Wärmeleitfähigkeit ca. 6000 W*(m*K)$^{-1}$). Allerdings zeigt sich hier ein schlechteres Leistungs-/Kosten-Verhältnis im Vergleich zu MWCNT. Die Zylinderdurchmesser von MWCNT liegen typischerweise im Bereich von 1 nm bis 100 nm, bevorzugt von 5 bis 50 nm, mit einer Länge von 500 nm bis 1000 um.

Gemäß weiteren Ausführungsvarianten kann der dritte Füllstoff MWCNT umfassen und gleichzeitig der zweite und/oder erste Füllstoff Industrieruß umfassen oder aus diesem bestehen, da hier ebenfalls eine Verbesserung der Wärmeleitfähigkeit (z. B. bis zu 200 W*(m*K)$^{-1}$) erreicht werden kann. Da der Einsatz von beispielhaft Industrieruß eine deutlich geringere Reißfestigkeit mit Werten von < 0,4 GPa aufweist, ist eine Kombination aus beiden oder weiteren Füllstoffen möglich und kann zu einer Verbesserung der Gesamtsplitausbeute und zu einer Verbesserung der Gesamtkosten im Splitting-Verfahren führt.

Hierbei liegen die mittleren Durchmesser der Rußpartikel (Carbon Black) im Bereich von 5 nm bis 500 nm, bevorzugt von 20 nm bis 200 nm, besonders bevorzugt von 40 nm bis 100 nm. Weiterhin können die Füllstoffe Kieselsäure, beispielsweise pyrogene Kieselsäure, umfassen oder aus dieser bestehen. Zusätzlich oder alternativ kann ein weiterer Füllstoff umfassend oder bestehend aus Kieselsäure im Polymer-Hybrid-Material vorgesehen sein.

Pyrogene Kieselsäure kann ein dreidimensionales Netzwerk ausbilden und dadurch zur Verbesserung der mechanischen Stabilität beitragen. Somit kann ein solcher Füllstoff der gezielten Einstellung der mechanischen Eigenschaften des Polymer-Hybrid-Materials dienen.

Einer oder mehrere der genannten Füllstoffe (erster, zweiter, dritter Füllstoff) können aus demselben Material bestehen, sofern dies mit der ihnen zugeschriebenen Funktion vereinbar ist. Beispielsweise kann sowohl der erste als auch der dritte Füllstoff Aluminium umfassen oder aus Aluminium bestehen. Aluminium lässt sich wie oben beschrieben sowohl zur Generierung von Kavitäten und damit zur Beschleunigung des Ablösens des Polymer-Hybrid-Materials vom Festkörper-Teilstück nutzen als auch zur Erhöhung der Temperaturleitfähigkeit. Eine derartige Ausgestaltung vereinfacht den Herstellungsprozess, da es ausreichend sein kann, nur einen oder zwei Füllstoffe hinzuzufügen, um alle Funktionen zu erfüllen.

Erster und zweiter sowie ggf. dritter Füllstoff können auch aus unterschiedlichen Materialien bestehen. Dadurch wird eine individuelle und damit bessere Anpassung des Füllstoffs an die gewünschte Funktion ermöglicht.

Das Polymer-Hybrid-Material, das oben beschrieben wurde, kann in einer Folie enthalten sein. Die Folie kann eine Dicke von beispielsweise 0,5 bis 5 mm aufweisen.

Das erläuterte Polymer-Hybrid-Material oder die Folie können in einem Splitting-Verfahren zur Teilung eines Festkörper-Ausgangsmaterial in zumindest zwei Festkörper-Teilstücke verwendet werden.

Insbesondere kann das Polymer-Hybrid-Material in einem Splitting-Verfahren verwendet werden, bei dem aus einem zylinderförmigen Festkörper-Ausgangsmaterial mehrere zylinderförmige, bevorzugt scheibenförmige, Festkörper-Teilstücke, insbesondere Wafer, erzeugt werden.

Unter Zylinder ist dabei ein von zwei parallelen, ebenen, kongruenten Flächen (Grund- und Deckfläche) und einer Mantel- bzw. Zylinderfläche begrenzter Körper zu verstehen, wobei die Mantelfläche von parallelen Geraden gebildet wird. Bevorzugt sind Grund- und Deckfläche kreisförmig ausgebildet und liegen deckungsgleich übereinander, so dass ein gerader Kreiszylinder resultiert. Gleichwohl sind auch andere Zylindergestaltungen, z. B. mit n-eckigen Grundflächen mit n = 3, 4, 5 oder 6, denkbar, wobei Grund- und Deckfläche bevorzugt deckungsgleich übereinander liegen.

Gemäß der vorliegenden Beschreibung wird unter einem Festkörper-Ausgangsmaterial ein monokristallines, polykristallines oder amorphes Material verstanden. Bevorzugt eignen sich wegen der stark anisotropen atomaren Bindungskräfte monokristalline Materialien mit einer stark anisotropen Struktur. Das Festkörper-Ausgangsmaterial weist bevorzugt ein Material oder eine Materialkombination aus einer der Hauptgruppen 3, 4, 5 und/oder 12 des Periodensystems der Elemente, insbesondere eine Kombination aus Elementen der 3., 5. und der 12. Hauptgruppe, auf oder besteht aus einem solchen Material, wie z. B. Silizium Si, Siliciumcarbid SiC, SiGe, Germanium Ge, Galliumarsenid GaAs, Indiumphosphid InP, Galliumnitrid GaN, Aluminiumoxid $Al_2O_3$ (Saphir), Aluminiumnitrid AlN.

Daneben kann das Halbleiter-Ausgangsmaterial beispielsweise auch Zinkoxid ZnO, Gallium(III)-oxid $Ga_2O_3$, Galliumphosphid GaP, Indiumarsenid InAs, Indiumnitrid InN, Aluminiumarsenid AlAs oder Diamant aufweisen oder aus einem solchen Material bestehen.

Weiterhin kann das Festkörper-Ausgangsmaterial eine Keramik (z. B. $Al_2O_3$ - Alumiumoxid) aufweisen oder aus einer Keramik bestehen, bevorzugte Keramiken sind dabei z. B. Perovskitkeramiken (wie z.B. Pb-, O-, Ti/Zr-haltige Keramiken) im Allgemeinen und Blei-Magnesium-Niobate, Bariumtitanat, Lithiumtitanat, Yttrium-Aluminium-Granat, insbesondere Yttrium-Aluminium-Granat Kristalle für Festkörperlaseranwendungen, SAW-Keramiken (surface acoustic wave), wie z. B. Lithiumniobat, Galliumorthophosphat, Quartz, Calziumtitanat, etc. im Speziellen.

Das Festkörper-Ausgangsmaterial weist somit bevorzugt ein Halbleitermaterial oder ein Keramikmaterial auf bzw. besonders bevorzugt besteht der Festkörper aus mindestens einem Halbleitermaterial oder einem Keramikmaterial. Es ist weiterhin denkbar, dass der Festkörper ein transparentes Material aufweist oder teilweise aus einem transparenten Material, wie z. B. Saphir, besteht bzw. gefertigt ist.

Weitere Materialien, die hierbei als Festkörper-Ausgangsmaterial alleine oder in Kombination mit einem anderen Material in Frage kommen, sind z. B. "wide band gap"-Materialien, InAlSb, Hochtemperatursupraleiter, insbesondere seltene Erden Cuprate (z. B. $YBa_2Cu_3O_7$). Es ist zusätzlich oder alternativ denkbar, dass das Festkörper-Ausgangsmaterial eine Photomaske ist, wobei als Photomaskenmaterial im vorliegenden Fall bevorzugt jedes zum Anmeldetag bekannte Photomaskenmaterial und besonders bevorzugt Kombinationen daraus verwendet werden können.

Ein erfindungsgemäßes Splitting-Verfahren umfasst die folgenden Schritte: Zunächst wird das zu teilende Festkörper-Ausgangsmaterial mit einer freiliegenden Oberfläche bereitgestellt. Das Festkörper-Ausgangsmaterial kann wie zuvor beschrieben beschaffen sein, beispielsweise eine zylinderförmige Gestalt aufweisen und aus einem der aufgeführten Materialien bestehen.

Auf zumindest diese Oberfläche wird ein Polymer-Hybrid-Material aufgebracht, so dass eine entsprechende Verbundstruktur resultiert. Das aufgebrachte Polymer-Hybrid-Material werden im Folgenden auch als Aufnahmeschicht bezeichnet. Die Dicke einer solchen Aufnahmeschicht kann beispielsweise zwischen 0,5 mm und 5 mm liegen.

Optional kann das Polymer-Hybrid-Material auch auf mehrere freiliegende Oberflächen, insbesondere auf parallel zueinander angeordnete Oberflächen aufgebracht werden.

Insbesondere kann es sich um ein zylinderförmiges Festkörper-Ausgangsmaterial handeln. In diesem Fall wird das Polymer-Hybrid-Material auf eine freiliegende Grund- und/oder Deckfläche aufgebracht. Dies kann beispielsweise durch Aufkleben einer Folie bestehend aus dem Polymer-Hybrid-Material erfolgen.

Das Aufbringen des Polymer-Hybrid-Materials auf die freiliegende Oberfläche des Festkörper-Ausgangsmaterials kann auch erfolgen, indem das Polymer-Hybrid-Material direkt auf dieser Oberfläche erzeugt wird, beispielsweise, indem das nachstehend beschriebene Verfahren zur Herstellung eines Polymer-Hybrid-Materials auf dieser Oberfläche durchgeführt wird. So kann eine Vorläufersubstanz des Polymer-Hybrid-Materials aus flüssiger Phase auf der freiliegenden Oberfläche des Festkörper-Ausgangsmaterials aufgetragen werden, dem sich ein physikalischer und/oder chemischer Vorgang, beispielsweise Verdunstung und/oder Vernetzungsreaktionen, zur Ausbildung des eigentlichen Polymer-Hybrid-Material anschließt.

Darauffolgend wird die Verbundstruktur mit einem Spannungsfeld derart beaufschlagt, dass das Festkörper-Ausgangsmaterial entlang einer Ablöseebene innerhalb des Festkörper-Ausgangsmaterials in zumindest zwei Festkörper-Teilstücke gespalten wird.

Das Spannungsfeld kann durch thermische Beaufschlagung der Aufnahmeschicht, beispielsweise durch plötzliches Abkühlen oder Erwärmen, insbesondere durch plötzliches Abkühlen mittels flüssigen Stickstoffs, erfolgen, wobei das Spannungsfeld aufgrund der unterschiedlichen Wärmeausdehnungskoeffizienten des Festkörper-Ausgangsmaterials und des Polymer-Hybrid-Materials sowie der resultierenden signifikanten Änderung des E-Moduls entsteht.

Die thermische Beaufschlagung stellt bevorzugt ein Abkühlen der Aufnahmeschicht unter die Umgebungstemperatur und bevorzugt unter 10 °C und besondere bevorzugt unter 0 °C und weiter bevorzugt unter -10 °C oder unter -40 °C dar.

Die Abkühlung der Aufnahmeschicht erfolgt höchst bevorzugt derart, dass zumindest ein Teil der Aufnahmeschicht einen Glasübergang vollzieht. Die Abkühlung kann hierbei eine Abkühlung auf unter -100 °C sein, die z. B. mittels flüssigen Stickstoffs bewirkbar ist. Diese Ausführungsform ist vorteilhaft, da sich die Aufnahmeschicht in Abhängigkeit von der Temperaturveränderung zusammenzieht und/oder einen Glasübergang erfährt und die dabei entstehenden Kräfte auf das Festkörper-Ausgangsmaterial übertragen werden, wodurch mechanische Spannungen in dem Festkörper erzeugbar sind, die zum Auslösen eines Risses und/oder zur Rissausbreitung führen, wobei sich der Riss zunächst entlang der ersten Ablöseebene zum Abspalten der Festkörperschicht ausbreitet.

In einem weiteren Schritt wird das Polymer-Hybrid-Material oder die Folie vom Festkörper-Teilstück, beispielsweise durch eine chemische Reaktion, ein physikalischen Ablösevorgang und/oder mechanisches Abtragen, entfernt.

Der Ablösevorgang des Polymer-Hybrid-Materials vom Festkörper-Teilstück kann bei moderater Umgebungstemperatur, z. B. im Bereich von 20 °C bis 30 °C stattfinden, bevorzugt im höheren Temperaturbereich von 30 °C bis 95 °C, z. B. von 50 °C bis 90 °C, oder aber beispielsweise auch in einem unteren Temperaturbereich zwischen 1 °C und 19 °C.

Der erhöhte Temperaturbereich kann eine Verkürzung einer chemischen Ablösereaktion aufgrund einer Erhöhung der Reaktionsgeschwindigkeit ermöglichen, z. B. im Falle der Verwendung einer Opferschicht zwischen dem Polymer-Hybrid-Material und dem Festkörper. Im Falle der Verwendung einer Opferschicht kann das Ablösen in wässriger Lösung erfolgen, vorteilhaft bei einem pH-Wert im Bereich von 2 - 6.

Gemäß verschiedenen Ausführungsvarianten kann beispielhaft der Ablösevorgang in Form einer Behandlung mit einer Lösung aus einem geeigneten apolaren Lösungsmittel erfolgen, wobei moderate Umgebungstemperaturen im Bereich von 1 °C bis 50 °C bevorzugt und von 20°C bis 40°C besonders bevorzugt sind.

Ein besonderer Vorteil hierbei ist das Ablösen ohne eine Temperatureinwirkung auf die Folie. Hierbei können vorteilhaft aliphatische und aromatische Kohlenwasserstoffe wie z. B. Toluol, n-Pentan, n-Hexan, aber auch halogenierte Lösungsmittel, wie z. B. Tetrachlorkohlenstoff, angewendet werden. Hierbei können zusätzliche Kräfte in das abzulösende Polymer-Hybrid-Material und die Grenzfläche zum Festkörper-Teilstück eingebracht werden, da durch eine Lösungsmittelbehandlung eine sehr starke reversible Quellung des Polymer-Hybrid-Material auftreten kann, wodurch das Ablösen insgesamt vereinfacht wird.

Gemäß weiteren Ausführungsvarianten kann eine Kombination mit dem oben beschriebenen Ablösemechanismus der Opferschicht und der Behandlung mit einem geeigneten apolaren Lösungsmittel erfolgen - ebenfalls ohne Temperatureinwirkung auf die Folie.

Gemäß weiteren Ausführungsvarianten kann zur Entfernung des Polymer-Hybrid-Materials oder der Folie vom Festkörper-Teilstück eine sequenzielle Folge und/oder eine partielle oder vollständige flächige Behandlung mit geeigneten polaren Lösungsmitteln, wie z. B. primären oder sekundären Alkoholen, z. B. Methanol, Ethanol, Isopropanol, oder Ketonen, wie z. B. Aceton, Butanon, Ethylmethylketon, Cyclohexanon, gefolgt von einer partiellen oder vollständigen Behandlung mit einem apolaren Lösungsmittel, vorteilhaft einem aliphatischen Kohlenwasserstoff, wie z. B. n-Pentan, n-Hexan, oder aromatischen Kohlenwasserstoff, wie z. B. Toluol, oder einem halogenierten Lösungsmittel, wie z. B. Tetrachlorkohlenstoff, oder einem Silikonöl oder Kerosin genutzt werden.

Hierbei werden moderate Umgebungstemperaturen im Bereich von 1 °C bis 50 °C bevorzugt und im Bereich von 20 °C bis 30 °C besonders bevorzugt. Eine Kombination mit dem oben beschriebenen Ablösemechanismus der Opferschicht und der sequenziellen Behandlung mit einem geeigneten polaren und apolaren Lösungsmittel kann ebenfalls erfolgen.

Gemäß weiteren Ausführungsvarianten kann zur Entfernung des Polymer-Hybrid-Materials oder der Folie vom Festkörper-Teilstück zusätzlich und auch separat eine ortsaufgelöste Ultraschallbehandlung oder Megaschallbehandlung (Frequenzbereich oberhalb von 400 kHz bis 2 MHz) der Festkörper-Teilstücke mit dem Polymer-Hybrid-Material erfolgen. Die Schallbehandlung kann auch frequenzmoduliert erfolgen, um z. B. eine homogenere Energieverteilung auf dem Festkörper-Teilstück zu ermöglichen.

Für den Bereich des Ultraschalls können Leistungsschall mit einem Frequenzbereich von 20 kHz bis 100 kHz oder auch Hochfrequenzschall mit einem Frequenzbereich von 100 kHz bis 1 MHz zum Einsatz kommen.

Aufgrund dieser Frequenzen kommt es in flüssigen Medien zu Kavitationsvorgängen mit Folgeerscheinungen, wie z. B. kollabierenden Kavitationsblasen. An Phasengrenzen, wie z. B. zwischen dem Festkörper-Teilstück und dem Polymer-Hybrid-Material kommt es im Nanosekundenbereich zu Implosion und Deformation von sich dynamisch bildenden Kavitationsblasen und der Ausbildung eines Microjets.

Die ortsaufgelöste Energieabgabe geschieht in Form von enormer adiabatischer Erwärmung auf sehr kleinem Raum durch die sehr schnelle Kompression des Gases. Hierbei treten extreme Temperaturen von bis zu 5000 Kelvin und Drücke bis zu 500 bar auf, die neue, sonst nicht stattfindende physikalische Ablösemechanismen und chemische Ablösereaktionen im Bereich der Grenzschicht ermöglichen.

Diese enormen Druckunterschiede resultieren aus dem Rückstoß der Blasenfront nach außen (implodierende Schockwelle). Hierbei kommt es zu stark erhöhten Ablösereaktionsgeschindigkeiten.

Gemäß weiteren Ausführungsvarianten kann zusätzlich nachgelagert eine flächige Megaschall- und/oder Ultraschallbehandlung vorteilhaft sein, da hierbei die Eindringtiefe auch in deutlich kleinere Strukturen, z. B. um-Strukturen bei einer Megaschallbehandlung, ermöglicht wird. Somit können besonders hohe Qualitätsreinheitsansprüche, wie z. B. im Falle von Halbleiterwafern, realisiert werden.

Optional kann zwischen dem Festköper-Ausgangsmaterial und dem Polymer-Hybrid-Material oder der Folie eine Opferschicht vorgesehen sein, die das Entfernen des Polymer-Hybrid-Materials oder der Folie nach erfolgter Teilung vereinfacht, indem beispielsweise die Opferschicht durch eine geeignete chemische Reaktion zersetzt wird.

Während die Polymermatrix der Generierung der zur Teilung des Festkörper-Ausgangsmaterials notwendigen Spannungen dient, obliegen dem oder den Füllstoffen die oben beschriebenen Aufgaben.

Insbesondere kann durch den ersten Füllstoff die Entfernung des Polymer-Hybrid-Materials oder der Folie beschleunigt werden, indem der An- und Abtransport des Lösungsmittels und der gelösten Bestandteile bzw. der Reaktionsedukte und -produkte verbessert wird. Dadurch können die nach dem Stand der Technik bisher erforderlichen zusätzlichen Spannungen bis hin zu einem kompletten Verzicht reduziert werden, so dass dadurch verursachte Beschädigungen der Festkörper-Teilstücke vermieden werden können. Im Ergebnis resultieren eine verkürzte Prozesszeit und eine verbesserte Gesamtausbeute.

Zudem wird die Prozessstabilität des Gesamtverfahrens erhöht, da aufgrund des möglichen Verzichts auf das Einbringen zusätzlicher Spannungen weniger Prozessschritte notwendig sind.

Unterliegen die Polymermatrix und/oder die Füllstoffe keiner chemischen Reaktion, so ist zudem deren Wiederverwendung möglich. Beispielsweise kann eine Folie zur Wiederverwendung geeignet sein.

Eine Wiederverwendung einer abgetrennten Folie aus Polymer-Hybrid-Material setzt regelmäßig voraus, dass sich das viskoelastische Folienverhalten durch den Ablöseprozess nicht wesentlich verändert. Hierbei dürfen sich die möglichen Wegänderungen bei einer entsprechenden Krafteinwirkung nur soweit ändern, dass die resultierenden Zugkräfte zur Separierung und Rissausbreitung homogen zur Verfügung gestellt werden können, ohne dass es zu einer Beschädigung der Folie kommt.

Mechanische Beschädigungen, vor allem im Randbereich der Folie (z. B. Einrisse) können hierbei besonders unvorteilhaft sein, da dies mit einer hohen Wahrscheinlichkeit nur zu einer partiellen Entfernung der Folie führt und eine Wiederverwendung erschwert werden kann.

Gemäß verschiedenen Ausführungsvarianten kann das abgetrennte Festkörper-Teilstück über einen Vakuumchuck mit einer Kanalstruktur oder bevorzugt einer Pinstruktur fixiert werden, wobei eine möglichst gleichmäßige Kräfteverteilung im Festkörper-Teilstück erzielt werden kann. Nachfolgend erfolgt die Behandlung mit dem jeweilig geeigneten apolaren oder polaren Lösungsmittel.

Generell kann, sobald eine hinreichende örtliche Delamination erfolgt ist, eine Abschälung per Hand durchgeführt werden oder aber das Polymer-Hybrid-Material oder die einzelne Folie wird mit Hilfe eines Rolle-zu-Rolle Prozesses vom Festkörperteilstück vollständig abgetrennt.

Für einen solchen Rolle-zu-Rolle Prozess kann in einem Zwischenschritt ein temporärer Hilfsträger auf das Polymer-Hybrid-Material oder die Polymer-Hybrid-Folie aufgeklebt- und/oder bevorzugt heiß auflamiert werden, wobei im Vergleich zur Grenzschicht der Folie zum Festkörperteilstück deutlich höhere Adhäsionskräfte zwischen dem temporären Hilfsträger und der Folie erzeugt werden. Entscheidend hierbei sind die Temperatur der beteiligten Walzen, die Umdrehungsgeschwindigkeit, der Walzenpressdruck sowie die Zuführgeschwindigkeit. Üblicherweise können eine kleinere Umdrehungsgeschwindigkeit, ein höherer Walzenpressdruck und eine kleiner Zuführgeschwindigkeit eine bessere Adhäsion der Folie auf dem Hilfsträger begünstigen.

Somit ist im nachgelagerten Rolle-zu-Rolle Prozess eine vollständige Abtrennung der Folie vom Festkörperteilstück möglich.

Gemäß weiteren Ausführungsvarianten kann der temporäre Hilfsträger in jedem Teilschritt vor der Zuführung durch eine Plasmabehandlung gereinigt und anschließend aktiviert werden. Dies ermöglicht eine verbesserte Verbindung des temporären Hilfsträgers mit der Folie.

In weiteren Ausführungsvarianten kann der temporäre Hilfsträger mehrfach in Form eines Endlosbandes eingesetzt werden.

Die Entfernung des Polymer-Hybrid-Materials oder der Folie kann derart beschleunigt werden, dass auf eine zusätzliche Opferschicht verzichtet werden kann. Dies trägt zu einer weiteren Vereinfachung und damit zur Erhöhung der Prozessstabilität des Splitting-Verfahrens bei.

Das Polymer-Hybrid-Material oder die Folie können direkt auf die freiliegende Oberfläche des Festkörper-Ausgangsmaterials aufgebracht werden oder es kann eine dazwischenliegende Opferschicht vorgesehen werden.

Das Polymer-Hybrid-Material oder die Folie können vor dem Aufbringen auf die Oberfläche des Festkörper-Ausgangsmaterials oder die Opferschicht mittels Niedertemperaturplasmas, z. B. Kaltplasma aktiviert werden. Dabei kann eine Aktivierung der Polymermatrix und/oder des oder der Füllstoffe wie vorstehend beschrieben erfolgen. Zusätzlich oder alternativ kann zudem die Oberfläche des Festkörper-Ausgangsmaterials oder die Opferschicht plasmabehandelt werden.

Dies begünstigt eine homogenere und einstellbare Haftung auf dem Festkörper-Ausgangsmaterial bzw. der Opferschicht und ermöglicht eine bessere Kraftübertragung.

Beispielsweise lässt sich durch eine gezielte Plasmabehandlung eine ortsaufgelöste Oberflächenmorphologie realisieren. Dies kann zu gewünschten Zielprofilen wie z. B. unterschiedlich ortsaufgelösten Adhäsions- oder Kohäsionseigenschaften der Oberfläche des Polymer-Hybrid-Materials und/oder der Oberfläche der Festkörper-Ausgangsmaterials und/oder der sich anschließenden Opferschicht dienen.

Eine Folie kann mittels Laminieren oder Kleben direkt auf die Oberfläche des Festkörper-Ausgangsmaterials oder auf die Opferschicht aufgebracht werden. Laminieren ermöglicht eine bessere Haftung, insbesondere im Randbereich. Damit kann ein Ausbrechen des Festkörpermaterials im Randbereich während der Teilung weitgehend vermieden werden, wodurch die Ausschussrate verringert werden kann.

Optional kann eine Ablöseebene innerhalb des Festköper-Ausgangsmaterials mittels mindestens einer Strahlungsquelle vorgegeben werden, beispielsweise mittels eines Lasers. Damit kann die Position der Ablöseebene genau festgelegt werden, sodass eine sehr kleine TTV, insbesondere kleiner als 200 $\mu$m oder 100 $\mu$m oder kleiner als 80 $\mu$m oder kleiner als 60 $\mu$m oder kleiner als 40 $\mu$m oder kleiner als 20 $\mu$m oder kleiner als 10 $\mu$m oder kleiner als 5 $\mu$m, insbesondere kleiner als 4, 3, 2, 1 $\mu$m ermöglicht wird.

Die Strahlenbeaufschlagung des Festkörper-Ausgangsmaterials schafft somit in einem ersten Schritt eine Art Perforation im Inneren des Festkörper-Ausgangsmaterials entlang der in einem zweiten Schritt die Rissausbreitung erfolgt bzw. entlang der das Festkörper-Teilstück von dem Festkörper-Ausgangsmaterial abgetrennt wird.

Mindestens oder genau eine Strahlungsquelle kann zum Bereitstellen der in das Festkörper-Ausgangsmaterial einzubringenden Strahlung derart konfiguriert sein, dass die von ihr ausgestrahlten Strahlen die Defekte an vorbestimmten Orten innerhalb des Festkörper-Ausgangsmaterials erzeugen. Diese Ausführungsform ist vorteilhaft, da mittels einer Strahlungsquelle, insbesondere mittels eines Lasers, äußerst genau Defekte in dem Festkörper-Ausgangsmaterial erzeugbar sind.

Die Strahlungsquelle kann derart eingestellt werden, dass die von ihr ausgestrahlten Strahlen zum Erzeugen der Ablöseebene auf eine definierte Tiefe, insbesondere in eine Tiefe < 100 $\mu$m, in das Festkörper-Ausgangsmaterial eindringen. Bevorzugt wird die Ablöseebene parallel beabstandet zu einer äußeren und bevorzugt ebenen Oberfläche des Festkörper-Ausgangsmaterials ausgebildet. Bevorzugt ist die Ablöseebene weniger als 100 $\mu$m und bevorzugt weniger als 50 $\mu$m und besonders bevorzugt weniger als oder gleich 20, 10, 5 oder 2 $\mu$m von der ebenen Oberfläche des Festkörper-Ausgangsmaterials beabstandet innerhalb des Festkörper-Ausgangsmaterials ausgebildet.

Der Festkörper kann mit einer vorgegebenen Wellenlänge und/oder Leistung beaufschlagt werden, wobei die vorgegebene Wellenlänge bevorzugt an das jeweilige Material angepasst ist. Diese Ausführungsform ist vorteilhaft, da die Defektgröße durch die Wellenlänge und/oder die Leistung beeinflussbar ist.

Das Festkörper-Ausgangsmaterial kann an einer Halteschicht zum Halten des Festkörpers angeordnet sein, wobei die Halteschicht an einem ersten ebenen Flächenanteil des Festkörper-Ausgangsmaterials angeordnet wird, wobei der erste ebene Flächenanteil des Festkörper-Ausgangsmaterials von einem zweiten ebenen Flächenanteil des Festkörper-Ausgangsmaterials beabstandet ist, wobei am zweiten ebenen Flächenanteil die Aufnahmeschicht angeordnet ist und wobei die Ablöseebene gegenüber dem ersten ebenen Flächenanteil und/oder dem zweiten ebenen Flächenanteil parallel ausgerichtet wird bzw. parallel erzeugt wird.

Diese Ausführungsform ist vorteilhaft, da das Festkörper-Ausgangsmaterial zumindest abschnittweise und bevorzugt vollständig zwischen der Halteschicht und der Aufnahmeschicht angeordnet ist, wodurch mittels einer dieser Schichten oder mittels beider Schichten die Spannungen zur Risserzeugung bzw. Rissausbreitung in den Festkörper einleitbar sind.

Die Halteschicht kann an einer zumindest abschnittsweise ebenen Fläche einer Stabilisierungseinrichtung angeordnet ist, die zumindest teilweise aus mindestens einem Metall besteht.

Die Stabilisierungseinrichtung ist bevorzugt eine Platte, insbesondere eine Platte die Aluminium aufweist oder daraus besteht. Diese Ausführungsform ist vorteilhaft, da durch die Stabilisierungseinrichtung und die Halteschicht das Festkörper-Ausgangsmaterial definiert bzw. fest gehalten wird, wodurch die Spannungen sehr genau in dem Festkörper-Ausgangsmaterial erzeugt werden können.

Die Spannungen können in dem Festkörper derart einstellbar bzw. erzeugbar sein, dass die Rissauslösung und/oder die Rissausbreitung zum Erzeugen einer Topografie der sich in der Rissebene ergebenden Oberfläche steuerbar ist. Die Spannungen sind somit bevorzugt in unterschiedlichen Bereichen des Festkörpers bevorzugt zumindest zeitweise unterschiedlich stark erzeugbar. Diese Ausführungsform ist vorteilhaft, da durch Steuerung der Rissauslösung und/oder des Rissverlaufs die Topographie der erzeugten bzw. abgetrennten Festkörperschicht vorteilhaft beeinflussbar ist.

Ein Verfahren zur Herstellung des zuvor beschriebenen Polymer-Hybrid-Materials umfasst das Hinzufügen eines oder mehrerer Füllstoffe zu einem Monomer, einer Monomerlösung oder einem unvernetzten Polymer, bevorzugt einem unvernetzten Polydimethylsiloxan. Diese Mischung wird während oder nach der Zugabe des oder der Füllstoffe polymerisiert und/oder vernetzt.

Alternativ können der oder die Füllstoffe auch zu einer Polymerschmelze hinzugefügt werden, so dass das Polymer-Hybrid-Material durch Abkühlen auf eine Temperatur unterhalb der Schmelztemperatur erhalten wird.

Die Verteilung des oder der Füllstoffe in der Polymermatrix kann durch die Geschwindigkeit der Polymerisation und/oder Vernetzung oder Abkühlung gesteuert werden. Dazu wird ausgenutzt, dass sich die Viskosität durch die Polymerisation, Vernetzung oder Abkühlung ändert, so dass sich die Sedimentationsgeschwindigkeit der Füllstoffe verringert.

Durch eine geeignete Bewegung des Gemischs aus Füllstoff und Polymermatrix während der Polymerisierung, Vernetzung oder Abkühlung kann beispielsweise eine gleichmäßige Füllstoffverteilung erreicht werden.

Eine langsame Polymerisierung, Vernetzung oder Abkühlung ohne Bewegung führt durch Einwirken der Erdgravitationskraft hingegen aufgrund der Sedimentation zu einer Füllstoffanreicherung im erdnahen Bereich, sofern der Füllstoff eine höhere Dichte als die Polymermatrix aufweist. Dies kann zur Anreicherung des Füllstoffs im Grenzbereich zum Festkörper-Ausgangsmaterials oder zur Opferschicht ausgenutzt werden, beispielsweise um dort gezielt durch geeignete Reaktionen Kavitäten zu generieren.

Die Verteilung des oder der Füllstoffe in der Polymermatrix kann auch durch eine anderweitige Beeinflussung der Sedimentationsgeschwindigkeit des oder der Füllstoffe gesteuert werden.

Neben dem Verhältnis der Dichten von Füllstoff und Polymermatrix beeinflusst auch die Partikelform die Sedimentation. Eine stark anisotrope Partikelform insbesondere mit einem hohen nichtrotationssymmetrischen Aspektverhältnis, wie sie beispielsweise Fasern eigen ist, führt beispielsweise zu einer Verzögerung der Sedimentation und zu einer sich graduell ändernden Füllstoffverteilung innerhalb der Polymermatrix.

Das Aspektverhältnis wird vorzugsweise verstanden als das Verhältnis von Länge zu Durchmesser, Länge zu Breite oder Länge zu Dicke.

Als Länge wird dabei immer die größte Ausdehnung eines Partikels in eine der Raumrichtungen gewählt.

Somit ist das Aspektverhältnis immer größer oder gleich eins. Das Aspektverhältnis von eins entspricht einer perfekten Kugelform. Abweichungen von einer Kugelform werden mit Aspektverhältnissen, die größer eins sind, beschrieben.

Beispielsweise weisen Fasern typischerweise ein sehr hohes Aspektverhältnis (stark anisotrope Partikelform) auf.

Je nach eingesetzten Füllstoffen oder der Kombination von Füllstoffen kann das Aspektverhältnis der Füllstoffpartikel größer als 100, 1000, 10.000, oft sogar größer 100.000 (z. B. bei Kohlenstoffnanoröhren), sein, wobei die vorliegende Erfindung hierauf nicht beschränkt sein soll.

Auch können bei stark anisotropen Füllstoffpartikeln zusätzliche Stabilisierungen durch Überstrukturen auftreten, die einer Sedimentation entgegen wirken. Bei nanoskaligen Füllstoffpartikeln sind zudem dreidimensionale Gerüststrukturen möglich, die eine Sedimentation weiter erschweren, so dass die Eigenschaften insbesondere im Grenzbereich gezielt beeinflusst werden können.

Hinzu kommt, dass aufgrund der Stokesschen Gleichung, welche auf dem Gesetz von Stokes aufbaut, der Partikelradius im Quadrat zur Sedimentationsgeschwindigkeit eingeht:

$$v_p = \frac{2\, r^2 g(\rho_p - \rho_f)}{9\eta}$$

mit

$v_p$    Sedimentationsgeschwindigkeit

$r$    Radius des sinkenden Partikels

$g$    Erdbeschleunigung

$\rho_p$    Dichte des Partikels

$\rho_f$    Dichte des Fluids

$\eta$    dynamische Viskosität des Fluids

Danach reduziert sich die Sedimentationsgeschwindigkeit gerade bei submikro- und nanoskaligen Partikeln im Verlauf der Polymervernetzungsreaktion.

Einer oder mehrere der hinzuzufügenden Füllstoffe können zudem als Inhibitor wirken. Zusätzlich oder alternativ können auch ein oder mehrere Inhibitoren zugesetzt werden. Dadurch kann beispielsweise eine ungewollte vorzeitige Polymerisation verhindert werden.

Beispielsweise kann einer der eingebrachten Füllstoffe zusätzlich als Reaktionsinhibitor wirken. Diese Inhibitoren können einen wesentlichen Einfluss auf die Vernetzungsreaktion haben, indem z. B. eine Verlangsamung der Reaktionsgeschwindigkeit durch entsprechende Radikalfänger oder Stabilisatoren erfolgt.

Hierbei kann die Lagerstabilität der einzelnen Komponenten aber auch die eigentliche Vernetzungsreaktion zum Polymer-Hybrid-Material gezielt verlangsamt werden. Somit sind längere Topfzeiten und eine Verlängerung der Verarbeitungszeit im Gesamtherstellprozess des Polymer-Hybrid-Materials möglich.

Im Falle eines Polysiloxannetzwerkes kann mit Hilfe von z. B. Fumarat- oder Maleat-basierten Inhibitoren, 2-Methylbutin-3-ol-2, 3,5-Dimethyl-1-hexin-3-ol oder bevorzugt mit Tetramethyltetravinylcyclotetrasiloxan eine deutliche Verlangsamung der Vernetzung erreicht werden. Im Falle des vierfach funktionellen Tetramethyltetravinylcyclotetrasiloxan können zusätzliche Vernetzungspunkten im Polymernetzwerk erhalten werden.

Es ist auch möglich, bei Silikonmatrices, wie z. B. Polydimethylsiloxan, die durch UV-Strahlung ausgehärtet werden, die notwendige Vernetzungszeit nachträglich durch einen als Inhibitor wirkenden Füllstoff einzustellen. Dies erfolgt durch eine Verringerung der Reaktionsgeschwindigkeit durch entsprechende Radikalfänger oder Stabilisatoren. Somit wird die Lagerungshaltbarkeit des Monomers, der Monomerlösung oder des unvernetzten Polymers durch die Verhinderung einer ungewollten vorzeitigen Polymerisation oder Vernetzung entsprechend erhöht.

Dies ist auch bei thermisch zu vernetzenden Systemen möglich, z. B. durch Zugabe von Schwefel, aminhaltigen Substanzen, Tetramethyltetravinylcyclotetrasiloxan, 2-Methylbutin-3-ol-2 oder durch Zugabe von Dimethylfumarat und Dimethylmaleat bei Systemen, die bei Raumtemperatur vulkanisiert werden (RTV-Systeme). Zudem kann in Hinblick auf die industrielle Verarbeitung die sog. Topfzeit eingestellt werden, so dass sinnvolle Batchchargengrößen realisiert werden können.

Mit Hilfe der beschriebenen Vorgänge können die Eigenschaften des Polymer-Hybrid-Materials gezielt an das jeweilige Festkörper-Ausgangsmaterials und die Prozessbedingungen des Splitting-Verfahrens angepasst werden. Beispielsweise ist es möglich, einen Füllstoff, der vorrangig der Schaffung von Kavitäten und damit der verbesserten Entfernung des Polymer-Hybrid-Materials dient, im Grenzbereich zum Festkörper-Teilstück anzuordnen, während ein weiterer Füllstoff zur Verbesserung der Wärmeleitung, z. B. der oben beschriebene dritte Füllstoff, möglichst gleichmäßig verteilt im Polymer-Hybrid-Material vorliegen kann oder vorrangig im Grenzbereich zur Umgebung angeordnet ist.

Optional kann das nach dem beschriebenen Verfahren erhaltene Polymer-Hybrid-Material um eine füllstofffreie Schicht ergänzt werden. Damit kann beispielsweise eine Verteilung des Füllstoffs in der Polymermatrix erhalten werden, bei der auf eine füllstofffreie Schicht zunächst ein Bereich mit einem hohen Füllstoffanteil folgt und daran anschließend der Füllstoffanteil wieder abnimmt.

Dies kann beispielsweise vorteilhaft sein, falls der Füllstoff die Haftung des Polymer-Hybrid-Materials auf dem Festkörper-Ausgangsmaterial negativ beeinflusst, aber dennoch eine hohe Füllstoffkonzentration im Grenzbereich zum Festkörper-Ausgangsmaterial benötigt wird, um nach erfolgter Teilung das Polymer-Hybrid-Material schneller vom Festkörper-Teilstück ablösen zu können.

Weitere Vorteile, Ziele und Eigenschaften der vorliegenden Erfindung werden anhand nachfolgender Beschreibung anliegender Zeichnungen erläutert, in welchen beispielhaft die erfindungsgemäße Waferherstellung dargestellt ist. Bauteile oder Elemente der erfindungsgemäßen Waferherstellung, welche in den Figuren wenigstens im Wesentlichen hinsichtlich ihrer Funktion übereinstimmen, können hierbei mit gleichen Bezugszeichen gekennzeichnet sein, wobei diese Bauteile oder Elemente nicht in allen Figuren beziffert oder erläutert sein müssen.

Einzelne oder alle Darstellungen der im Nachfolgenden beschriebenen Figuren sind bevorzugt als Konstruktionszeichnungen anzusehen, d. h. die sich aus der bzw. den Figuren ergebenden Abmessungen, Proportionen, Funktionszusammenhänge und/oder Anordnungen entsprechen bevorzugt genau oder bevorzugt im Wesentlichen denen der erfindungsgemäßen Vorrichtung bzw. des erfindungsgemäßen Produkts.

In den Zeichnungen zeigen:

Fig. 1a    eine schematische Darstellung eines Polymer-Hybrid-Materials mit einem ersten Füllstoff;

Fig. 1b    eine schematische Darstellung eines Polymer-Hybrid-Materials mit einem ersten und einem zweiten Füllstoff;

Fig. 1c    eine schematische Darstellung eines Polymer-Hybrid-Materials mit einem ersten, zweiten und dritten Füllstoff;

Fig. 2a    einen schematischen Aufbau zum Erzeugen von Defekten in einem Festkörper;

Fig. 2b    eine schematische Darstellung einer Schichtanordnung vor dem Abtrennen einer Festkörperschicht von einem Festkörper;

Fig. 2c    eine schematische Darstellung einer Schichtanordnung nach dem Abtrennen einer Festkörperschicht von einem Festkörper:

Fig. 3a    eine erste schematisch dargestellte Variante zur Defekterzeugung mittels Lichtwellen;

Fig. 3b    eine zweite schematisch dargestellte Variante zur Defekterzeugung mittels Lichtwellen: und

Fig. 4      eine schematische Darstellung der Ablöseebene.

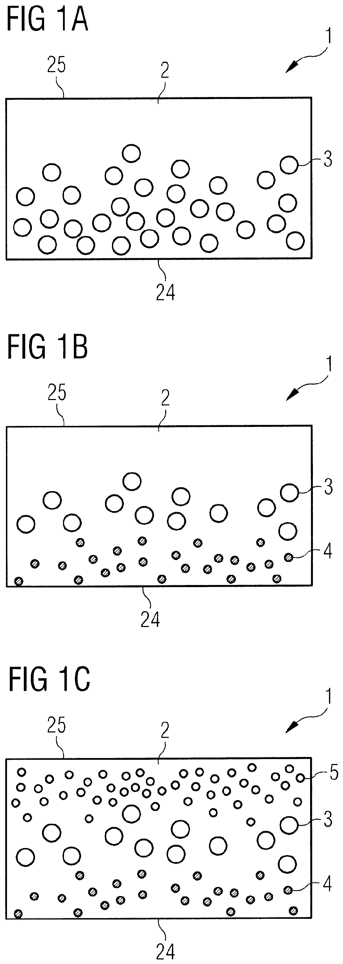

Fig. 1a zeigt ein Polymer-Hybrid-Material 1, bei dem in einer Polymermatrix 2 ein erster Füllstoff 3 eingebettet ist. Die Polymermatrix 2 im Beispiel besteht aus PDMS. Der erste Füllstoff 3 wirkt als Reaktant in einem Splitting-Verfahren während des Ablösens des Polymer-Hybrid-Materials 1 vom Festkörper-Teilstück 7 nach der Teilung und ermöglicht dadurch im Vergleich zu einem Polymermaterial ohne ersten Füllstoff ein schnelleres Ablösen des Polymer-Hybrid-Materials 1 vom Festkörper-Teilstück 7 nach der Teilung.

Im Beispiel besteht der erste Füllstoff 3 aus Aluminium oder Zink, so dass durch Reaktion mit Salzsäure ein gasförmiges Produkt entstehen kann.

Der erste Füllstoff 3 ist in der Polymermatrix 2 entlang eines Gradienten verteilt. Der Masseanteil des ersten Füllstoffs 3 ist im Bereich der unteren Grenzfläche 24 am höchsten und nimmt in Richtung der oberen Grenzfläche 25 ab.

Fig. 1b zeigt beispielhaft eine Ausführungsform des Polymer-Hybrid-Materials 1, wobei im Vergleich zur Ausführungsform gemäß Fig. 1a ein weiterer zweiter Füllstoff 4 vorhanden ist.

Dieser zweite Füllstoff 4 verbessert die Haftung des Polymer-Hybrid-Materials 1 auf dem Festkörper-Ausgangsmaterial 6 im Vergleich zu einem Polymer-Hybrid-Material 1 ohne zweiten Füllstoff 4.

Der zweite Füllstoff 4 ist in der Polymermatrix 2 so verteilt, dass sein Masseanteil in Richtung der unteren Grenzfläche 23 zunimmt und lässt sich bevorzugt mittels Kaltplasma aktivieren.

Fig. 1c zeigt beispielhaft eine weitere Ausführungsform des Polymer-Hybrid-Materials 1, wobei im Vergleich zur Ausführungsform gemäß Fig. 1b ein weiterer dritter Füllstoff 5 vorhanden ist.

Dieser dritte Füllstoff 5 umfasst ein Metall und weist im Vergleich zum Polymer der Polymermatrix 2 eine höhere Temperaturleitfähigkeit auf. Der dritte Füllstoff 5 weist den höchsten Anteil in einem Bereich angrenzend zur oberen Grenzfläche auf 25 auf.

In allen drei Ausführungsformen gemäß Fig. 1a, 1b und 1c beträgt der Masseanteil der Polymermatrix 2 am Polymer-Hybrid-Material 1 90 % oder mehr.

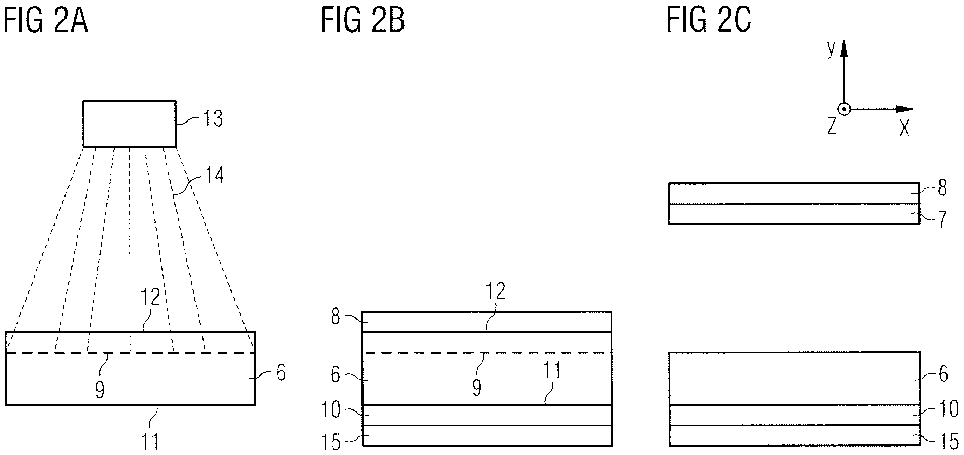

In Fig. 2a ist ein Festkörper-Ausgangsmaterial 6 gezeigt, das im Bereich einer Strahlungsquelle 13, insbesondere einem Laser, angeordnet ist. Das Festkörper-Ausgangsmaterial 6 weist bevorzugt einen ersten ebenen Flächenanteil 11 und einen zweiten ebenen Flächenanteil 12 auf, wobei der erste ebene Flächenanteil 11 bevorzugt im Wesentlichen oder genau parallel zu dem zweiten ebenen Flächenanteil 12 ausgerichtet ist.

Der erste ebene Flächenanteil 11 und der zweite Ebene Flächenanteil 12 begrenzen bevorzugt das Festkörper-Ausgangsmaterial 6 in einer Y-Richtung, die bevorzugt vertikal bzw. lotrecht ausgerichtet ist. Die ebenen Flächenanteile 11 und 12 erstrecken sich bevorzugt jeweils in einer X-Z-Ebene, wobei die X-Z-Ebene bevorzugt horizontal ausgerichtet ist.

Weiterhin lässt sich Fig. 2a entnehmen, dass die Strahlungsquelle 13 Strahlung 14 auf das Festkörper-Ausgangsmaterial 6 ausstrahlt. Die Strahlung 14 dringt je nach Konfiguration definiert tief in das Festkörper-Ausgangsmaterial 6 ein und erzeugt an der jeweiligen Position bzw. an einer vorbestimmten Position einen Defekt.

In Fig. 2b ist eine mehrschichtige Anordnung gezeigt, wobei das Festkörper-Ausgangsmaterial 6 die Ablöseebene 9 beinhaltet und im Bereich des ersten ebenen Flächenanteils 11 mit einer Halteschicht 10 versehen ist, die wiederum bevorzugt von einer weiteren Schicht überlagert wird, wobei die weitere Schicht bevorzugt eine Stabilisierungseinrichtung 15, insbesondere eine Metallplatte, ist.

An dem zweiten ebenen Flächenanteil 12 des Festkörper-Ausgangsmaterials 6 ist eine Aufnahmeschicht 8 angeordnet, welche aus Polymer-Hybrid-Material 1 besteht. Das Festkörper-Ausgangsmaterial 6 weist im Beispiel Silizium und/oder Gallium oder Perowskit auf und die Polymermatrix 2 des Polymer-Hybrid-Materials 1 und/oder die Halteschicht 10 bestehen zumindest teilweise und bevorzugt vollständig oder zu mehr als 75 % (Masseanteil) aus Polydimethylsiloxan (PDMS).

In Fig. 2c ist ein Zustand nach einer Rissauslösung und anschließender Rissführung gezeigt. Das Festkörper-Teilstück 7 haftet an der Aufnahmeschicht 8 und ist von dem verbleibenden Rest des Festkörpers-Ausgangsmaterials 6 beabstandet bzw. beabstandbar.

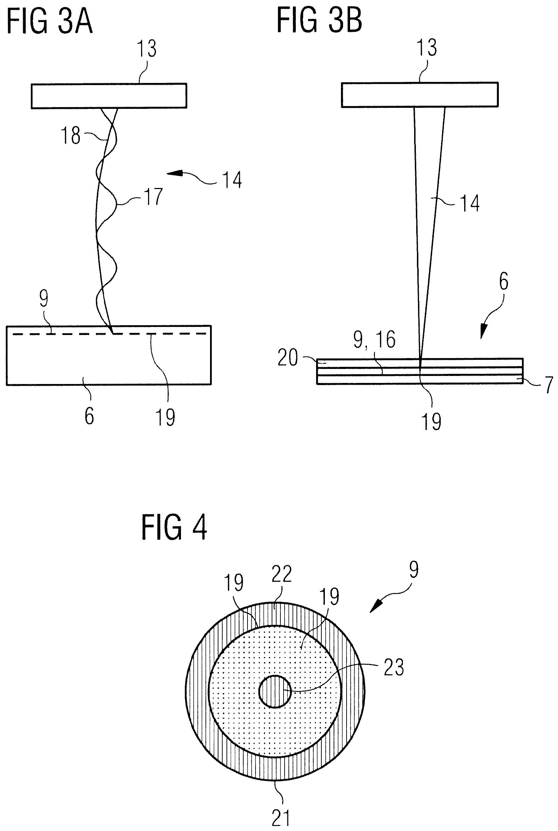

In den Fig. 3a und 3b sind Beispiele für die in Fig. 2a gezeigte Erzeugung einer Ablöseebene 9 durch die Einbringung von Defekten in ein Festkörper-Ausgangsmaterial 6 mittels Lichtstrahlung 14 gezeigt.

Durch das Polymer-Hybrid-Material 1 sollen beispielhaft mittels des nachfolgend geschilderten Verfahrens Festkörper-Teilstücke 7 in Form von Festkörperschichten, Festkörperplatten bzw. Wafern mit einer gleichmäßigen Dicke kostengünstig hergestellt werden. Insbesondere wird damit eine TTV von weniger als 120 $\mu$m erreicht.

Bei dem beispielhaft erläuterten Verfahren wird ein Polymer-Hybrid-Material 1, wie es vorstehend ausführlich dargestellt wurde, eingesetzt, wobei das Polymer-Hybrid-Material in Form einer Folie vorliegen kann. Dieses Verfahren umfasst dabei bevorzugt mindestens die Schritte:

- des Bereitstellens eines Festkörper-Ausgangsmaterials 6 zum Abtrennen mindestens eines Festkörper-Teilstücks 7 in Form einer Festkörperschicht,

- des Erzeugens von Defekten 19 mittels mindestens einer Strahlungsquelle 13, insbesondere eines Laser, in der inneren Struktur des Festkörper-Ausgangsmaterials 6 zum Vorgeben einer Ablöseebene 9, entlang der das Festkörper-Teilstück 7 vom Festkörper-Ausgangsmaterial 6 abgetrennt wird,

- des Anordnens einer Aufnahmeschicht 8 bestehend aus dem Polymer-Hybrid-Material 1,

- des thermischen Beaufschlagens der Aufnahmeschicht 8 zum, insbesondere mechanischen, Erzeugen von Spannungen in dem Festkörper-Ausgangsmaterial 6, wobei sich durch die Spannungen ein Riss in dem Festkörper-Ausgangsmaterial 6 entlang der Ablöseebene 9 ausbreitet, der das Festkörper-Teilstück 7 von dem Festkörper-Ausgangsmaterial 6 abtrennt;

- Entfernen des Polymer-Hybrid-Materials 1 vom Festkörper-Teilstück 7.

Diese Lösung ist vorteilhaft, da aufgrund der Strahlungsquelle die Ablöseschicht bzw. Defektschicht in dem Festkörper-Ausgangsmaterial erzeugbar ist, durch die der Riss bei der Rissausbreitung geleitet bzw. geführt wird, was die Realisierung sehr kleiner TTVs, insbesondere kleiner als 200 $\mu$m oder 100 $\mu$m oder kleiner als 80 $\mu$m oder kleiner als 60 $\mu$m oder kleiner als 40 $\mu$m oder kleiner als 20 $\mu$m oder kleiner als 10 $\mu$m oder kleiner als 5 $\mu$m, insbesondere kleiner als 4, 3, 2, 1 $\mu$m ermöglicht.

Die thermische Beaufschlagung stellt bevorzugt ein Abkühlen der Aufnahmeschicht unter die Umgebungstemperatur und bevorzugt unter 10 °C und besondere bevorzugt unter 0 °C und weiter bevorzugt unter -10 °C dar.

Die Abkühlung der Aufnahmeschicht erfolgt höchst bevorzugt derart, dass zumindest ein Teil der Aufnahmeschicht einen Glasübergang vollzieht. Die Abkühlung kann hierbei eine Abkühlung auf unter -100 °C sein, die z. B. mittels flüssigen Stickstoffs bewirkbar ist.

In Fig. 3a ist somit schematisch gezeigt, wie Defekte 19 in einem Festkörper-Ausgangsmaterial 6, insbesondere zur Erzeugung einer Ablöseebene 9 mittels einer Strahlungsquelle 13, insbesondere einem oder mehrerer Laser, erzeugbar ist.

Die Strahlungsquelle 13 emittiert dabei Strahlung 14 mit einer ersten Strahlungsanteil 17 mit einer ersten Wellenlänge und mit einem zweiten Strahlungsanteil 18 mit einer zweiten Wellenlänge. Die beiden Wellenlängen des ersten und zweiten Strahlungsanteils 17, 18 sind dabei derart aufeinander abgestimmt bzw. die Distanz zwischen der Strahlungsquelle 13 und der zu erzeugenden Ablöseebene 9 ist derart abgestimmt, dass die Strahlungsanteile 17, 18 im Wesentlichen oder genau auf der Ablöseebene 9 in dem Festkörper-Ausgangsmaterial 6 zusammentreffen, wodurch am Ort des Zusammentreffens infolge der Energien beider Strahlungsanteile 17, 18 Defekte 19 erzeugt werden.

Die Defekterzeugung kann dabei durch unterschiedliche oder kombinierte Zersetzungsmechanismen wie z. B. Sublimation oder chemische Reaktion erfolgen, wobei die Zersetzung dabei z. B. thermisch und/oder photochemisch initiiert werden kann.

In Fig. 3b ist ein fokussierter Lichtstrahl 14 gezeigt, dessen Brennpunkt bevorzugt in der Ablöseebene 9 liegt. Es ist hierbei denkbar, dass der Lichtstrahl 14 durch eine oder mehrere fokussierende Körper, insbesondere Linse/n (nicht gezeigt), fokussiert wird. Das Festkörper-Ausgangsmaterial 6 ist in dieser Ausführungsform mehrschichtig ausgebildet und weist bevorzugt eine teiltransparente oder transparente Substratschicht 20 auf, die bevorzugt aus Saphir besteht oder Saphir aufweist. Die Lichtstrahlung 14 gelangt durch die Substratschicht 20 auf die Ablöseebene 9, die durch eine Aktivierungsschicht 16 gebildet wird, wobei die Aktivierungsschicht 16 durch die Strahlung 14 derart beaufschlagt wird, dass thermisch und/oder photochemisch eine teilweise oder vollständige Zerstörung der Aktivierungsschicht 16 in dem Brennpunkt bzw. im Bereich des Brennpunkts bewirkt wird.

Es ist ebenfalls denkbar, dass die Defekte 19 zur Erzeugung der Ablöseschicht 9 im Bereich oder genau auf einer Grenzfläche zwischen dem Festkörper-Teilstück 7 und der Substratschicht 20 erzeugt werden. Somit ist ebenfalls denkbar, dass das Festkörper-Teilstück 7 auf einer Trägerschicht, insbesondere einer Substratschicht 20, erzeugt wird und mittels einer oder mehrerer Aktivierungsschichten 16 und/oder mittels der Erzeugung von Defekten 19 in einer Grenzfläche, insbesondere zwischen dem Festkörper-Teilstück 7 und der Trägerschicht, eine Ablöseebene 9 zum Ablösen bzw. Abtrennen des Festkörper-Teilstücks 7 erzeugbar ist.

In Fig. 4 ist eine Ablöseebene 9 gezeigt, die Bereiche mit unterschiedlichen Defektkonzentrationen 21, 22, 23 aufweist. Es ist hierbei denkbar, dass eine Vielzahl an Bereichen mit unterschiedlichen Defektkonzentrationen 21, 22, 23 eine Ablöseebene 9 bilden, wobei ebenfalls vorstellbar ist, dass die Defekte 19 in der Ablöseebene 9 im Wesentlichen oder genau gleichmäßig über die Fläche verteilt sind.

Die unterschiedlichen Defektkonzentrationen 21, 22, 23 können flächenmäßig gleich groß oder verschieden groß ausgebildet sein. Bevorzugt stellt eine erste erhöhte Defektkonzentration eine Rissauslösekonzentration 21 dar, die bevorzugt im Bereich des Randes oder sich zum Rand hin erstreckend bzw. dem Rand benachbart erzeugt wird.

Zusätzlich oder alternativ kann eine Rissführungskonzentration 22 derart ausgebildet werden, dass der das Festkörper-Teilstück 7 von dem Festkörper-Ausgangsmaterial 6 abtrennende Riss kontrollierbar oder steuerbar ist.

Weiterhin kann zusätzlich oder alternativ eine Zentrumskonzentration 23 erzeugt werden, die bevorzugt eine sehr ebene Oberfläche im Bereich des Zentrums des Festkörper-Ausgangsmaterials 6 ermöglicht.

Bevorzugt ist die Rissführungskonzentration 22 teilweise oder vollständig ringförmig oder umschließend ausgebildet und umschließt somit bevorzugt abschnittsweise und besondere bevorzugt vollständig das Zentrum des Festkörper-Ausgangsmaterials 6 bzw. des Festkörper-Teilstücks 7.

Es ist ferner denkbar, dass die Rissführungskonzentration 22 in einem ausgehend vom Rand des Festkörper-Ausgangsmaterials 6 und in Richtung Zentrum des Festkörper-Ausgangsmaterials 6 stufenweise oder stetig oder fließend abnimmt. Weiterhin ist denkbar, dass die Rissführungskonzentration 22 bandartig und homogen oder im Wesentlichen oder genau homogen ausgebildet ist.

**Bezugszeichenliste**

| | |
|---|---|
| 1 | Polymer-Hybrid-Material |
| 2 | Polymermatrix |
| 3 | erster Füllstoff |
| 4 | zweiter Füllstoff |
| 5 | dritter Füllstoff |
| 6 | Festkörper-Ausgangsmaterial |
| 7 | Festkörper-Teilstück |
| 8 | Aufnahmeschicht |
| 9 | Ablöseebene |
| 10 | Halteschicht |
| 11 | erster ebener Flächenanteil |
| 12 | zweiter ebener Flächenanteil |
| 13 | Strahlungsquelle |
| 14 | Strahlung |
| 15 | Stabilisierungseinrichtung |
| 16 | Aktivierungsschicht |
| 17 | erster Strahlungsanteil |
| 18 | zweiter Strahlungsanteil |
| 19 | Defekt |
| 20 | Substratschicht |
| 21 | Rissauslösekonzentration |
| 22 | Rissführungskonzentration |
| 23 | Zentrumskonzentration |
| 24 | untere Grenzfläche |
| 25 | obere Grenzfläche |
| X | erste Richtung |
| Y | zweite Richtung |
| Z | dritte Richtung |

**Patentansprüche**

1. Splitting-Verfahren zur Teilung eines Festkörper-Ausgangsmaterials (6) in zumindest zwei Festkörper-Teilstücke (7), umfassend die folgenden Schritte:

    a) Bereitstellen des Festkörper-Ausgangsmaterials (6) mit zumindest einer freiliegenden Oberfläche,
    b) Aufbringen eines Polymer-Hybrid-Materials (1) auf zumindest eine freiliegende Oberfläche des Festkörper-Ausgangsmaterials (6), so dass eine Verbundstruktur resultiert, wobei das Polymer-Hybrid-Material (1) umfasst:

        eine Polymermatrix (2),
        einen in der Polymermatrix (2) eingebetteten ersten Füllstoff (3), der ein Metall umfasst oder aus einem Metall besteht, und
        einen zweiten Füllstoff (4), der Kern-Schale-Polymerpartikel umfasst,

c) Beaufschlagung der Verbundstruktur mit einem Spannungsfeld derart, dass das Festkörper-Ausgangsmaterial (6) entlang einer Ablöseebene (9) innerhalb des Festkörper-Ausgangsmaterials (6) in die zumindest zwei Festkörper-Teilstücke (7) gespalten wird,
d) Entfernen des Polymer-Hybrid-Materials (1).

2. Splitting-Verfahren nach Anspruch 1,

wobei zunächst eine Opferschicht auf die freiliegende Oberfläche des Festkörper-Ausgangsmaterial (6) und wobei anschließend das Polymer-Hybrid-Material (1) auf die Opferschicht aufgebracht wird, so dass die Verbundstruktur das Festkörper-Ausgangsmaterial (6), die Opferschicht und das Polymer-Hybrid-Material (1) umfasst.

3. Splitting-Verfahren nach Anspruch 1 oder 2, wobei das Polymer-Hybrid-Material (1) und/oder das Festkörper-Ausgangsmaterial (6) oder die Opferschicht vor dem Aufbringen gemäß Schritt b) mittels Niedertemperaturplasmas aktiviert werden.

4. Splitting-Verfahren nach einem der Ansprüche 1 bis 3, wobei in Schritt b) das Polymer-Hybrid-Material als Bestandteil einer Folie mittels Laminieren oder Kleben auf zumindest eine Oberfläche des Festkörper-Ausgangsmaterial (6) oder auf die Opferschicht aufgebracht wird.

5. Splitting-Verfahren nach einem der Ansprüche 1 bis 4, wobei im Festkörper-Ausgangsmaterial (6) Defekte mittels mindestens einer Strahlungsquelle (13) zur Vorgabe der Ablöseebene (9) erzeugt werden.

6. Splitting-Verfahren nach einem der Ansprüche 1 bis 5, wobei das Polymer-Hybrid-Material (1) vom Festkörper-Teilstück (7) durch wenigstens eines der Folgenden entfernt wird:

a) Behandlung mit einem apolaren Lösungsmittel, insbesondere einem aliphatischen oder aromatischen Kohlenwasserstoff,
b) durch sequenzielle Behandlung mit einem polaren Lösungsmittel und einem apolaren Lösungsmittel,
c) mittels ortsaufgelöster Ultraschallbehandlung oder Megaschallbehandlung,
d) in einem Rolle-zu-Rolle-Prozess.

7. Splitting-Verfahren nach Anspruch 6, wobei ein temporärer Hilfsträger auf das Polymer-Hybrid-Material (1) aufgeklebt- und/oder heiß auflaminiert wird.

8. Splitting-Verfahren nach einem der vorangegangenen Ansprüche 1 bis 7, wobei das Polymer-Hybrid-Material (1) als Folie bereitgestellt wird.

9. Splitting-Verfahren nach einem der vorangegangenen Ansprüche,

wobei der erste Füllstoff (3) in der Polymermatrix (2) derart verteilt ist, dass der Masseanteil des ersten Füllstoffs (3) ausgehend von einer unteren Grenzfläche (24) des Polymer-Hybrid-Materials (1), die während des Splitting-Verfahrens mit dem Festkörper-Ausgangsmaterial (6) direkt oder indirekt über eine weitere Schicht verbunden ist, in Richtung einer gegenüberliegend zur unteren Grenzfläche (24) angeordneten weiteren Grenzfläche des Polymer-Hybrid-Materials (1), im Folgenden als obere Grenzfläche (25) bezeichnet, abnimmt und/oder wobei ein unterer Bereich des Polymer-Hybrid-Materials (1), der direkt an die untere Grenzfläche (24) angrenzt, und/oder
wobei ein oberer Bereich des Polymer-Hybrid-Materials (1), der direkt an die obere Grenzfläche (25) angrenzt, keinen ersten Füllstoff (3) aufweist.

10. Splitting-Verfahren nach einem der vorangegangenen Ansprüche,

wobei der erste Füllstoff (3) mit einem Reaktionsmittel, bevorzugt einem Oxidationsmittel, unter Freisetzung eines gasförmigen Produkts reagieren kann und/oder
wobei der erste Füllstoff (3) eine höhere Temperaturleitfähigkeit als das Polymer der Polymermatrix (2) aufweist.

11. Splitting-Verfahren nach einem der vorangegangenen Ansprüche,

wobei der zweite Füllstoff (4) in der Polymermatrix (2) derart verteilt ist, dass der Masseanteil des zweiten Füllstoffs (4) in Richtung der unteren Grenzfläche (24) zunimmt und/oder
wobei der zweite Füllstoff (4) mittels Niedertemperaturplasmas aktivierbar ist.

12. Splitting-Verfahren nach einem der vorangegangenen Ansprüche, wobei das Polymer-Hybrid-Material weiterhin aufweist:

einen dritten Füllstoff (5), der im Vergleich zu dem Polymer der Polymermatrix (2) eine höhere Temperaturleitfähigkeit und/oder einen höheren Elastizitätsmodul aufweist,
wobei der dritte Füllstoff (5) in der Polymermatrix (2) derart verteilt ist, dass der Masseanteil des dritten Füllstoffs (5) in Richtung der oberen Grenzfläche (25) zunimmt und/oder
wobei der dritte Füllstoff (3, 5) zumindest ein Metall, insbesondere Aluminium, Eisen, Zink und/oder Kupfer, umfasst.

13. Splitting-Verfahren nach einem der vorangegangenen Ansprüche, wobei der Masseanteil der Polymermatrix (2) am Polymer-Hybrid-Material (1) 80 % bis 99 %, bevorzugt 90 % bis 99 %, beträgt.

14. Splitting-Verfahren nach einem der vorangegangenen Ansprüche,

wobei das Polymer-Hybrid-Material (1) einen weiteren Füllstoff, umfassend anorganische oder organische Fasern, Kernschale- Partikel oder Kieselsäure, umfasst
und/oder, wobei das Polymer-Hybrid-Material (1) noch einen weiteren Füllstoff umfasst, der Kohlenstoff in Form von Industrieruß, Graphit, zerkleinerten Kohlenstofffasern oder Kohlenstoffnanofasern, insbesondere ein- oder mehrwandigen Kohlenstoffnanoröhrchen, umfasst oder aus diesen besteht.

## Claims

1. Splitting method for dividing a solid-state starting material (6) into at least two solid-state pieces (7), comprising the following steps:

a) providing the solid-state starting material (6) having at least one exposed surface,
b) applying a polymer hybrid material (1) to at least one exposed surface of the solid-state starting material (6), resulting in a composite structure, where the polymer hybrid material (1) comprises:

a polymer matrix (2),
a first filler (3) embedded in the polymer matrix (2) and comprising a metal or consisting of a metal, and
a second filler (4) comprising core-shell polymer particles,

c) treating the composite structure with a stress field such that the solid-state starting material (6) is split into the at least two solid-state pieces (7) along a plane of detachment (9) within the solid-state starting material (6),
d) removing the polymer hybrid material (1).

2. Splitting method according to claim 1,

wherein first a sacrificial layer is applied to the exposed surface of the solid-state starting material (6) and wherein subsequently the polymer hybrid material (1) is applied to the sacrificial layer, so that the composite structure comprises the solid-state starting material (6), the sacrificial layer and the polymer hybrid material (1).

3. Splitting method according to claim 1 or 2, wherein the polymer hybrid material (1) and/or the solid-state starting material (6) or the sacrificial layer are activated by means of low-temperature plasma before the application according to step b).

4. Splitting method according to any one of claims 1 to 3, wherein the polymer hybrid material is applied in step b) as a constituent of a film by means of lamination or adhesive bonding to at least one surface of the solid-state starting material (6) or to the sacrificial layer.

5. Splitting method according to any one of claims 1 to 4, wherein defects are generated in the solid-state starting material (6) by means of at least one radiation source (13) to specify the plane of detachment (9).

6. Splitting method according to any one of claims 1 to 5, wherein the polymer hybrid material (1) is removed form the solid-state piece (7) by at least one of the following:

   a) treatment with an apolar solvent, particularly an aliphatic or aromatic hydrocarbon,
   b) by sequential treatment with a polar solvent and an apolar solvent,
   c) by means of spatially resolved ultrasound treatment or megasound treatment,
   d) in a roll-to-roll process.

7. Splitting method according to claim 6, wherein a temporary auxiliary support is adhered and/or hot-laminated onto the polymer hybrid material (1).

8. Splitting method according to any one of the preceding Claims 1 to 7, wherein the polymer hybrid material (1) is provided as a film.

9. Splitting method according to any one of the preceding claims,

   wherein the first filler (3) is distributed in the polymer matrix (2) in such a way that the mass fraction of the first filler (3), starting from a lower interface (24) of the polymer-hybrid material (1) that during the splitting method is connected to the solid-state starting material (6) directly or indirectly via a further layer, decreases in the direction of a further interface of the polymer-hybrid material (1), referred to below as upper interface (25), which is disposed opposite the lower interface (24), and/or
   wherein a lower region of the polymer hybrid material (1) that directly borders the lower interface (24), and/or
   wherein an upper region of the polymer hybrid material (1) that directly borders the upper interface (25), contains no first filler (3).

10. Splitting method according to any one of the preceding claims,

   wherein the first filler (3) is able to react with a reaction agent, preferably an oxidizing agent, with release of a gaseous product, and/or
   wherein the first filler (3) has a higher temperature conductivity than the polymer of the polymer matrix (2).

11. Splitting method according to any one of the preceding claims,

   wherein the second filler (4) is distributed in the polymer matrix (2) in such a way that the mass fraction of the second filler (4) increases in the direction of the lower interface (24), and/or
   wherein the second filler (4) is activatable by means of low-temperature plasma.

12. Splitting method according to any one of the preceding claims, wherein the polymer hybrid material further comprises:

   a third filler (5), which in comparison to the polymer of the polymer matrix (2) has a higher temperature conductivity and/or a higher elasticity modulus,
   wherein the third filler (5) is distributed in the polymer matrix (2) in such a way that the mass fraction of the third filler (5) increases in the direction of the upper interface (25), and/or
   wherein the third filler (3, 5) comprises at least one metal, more particularly aluminium, iron, zinc and/or copper.

13. Splitting method according to any one of the preceding claims, wherein the mass fraction of the polymer matrix (2) in the polymer hybrid material (1) is 80% to 99%, preferably 90% to 99%.

14. Splitting method according to any one of the preceding claims,

   wherein the polymer hybrid material (1) comprises a further filler, comprising organic or inorganic fibres, core-shell particles or silica,
   and/or wherein the polymer hybrid material (1) additionally comprises a further filler which comprises or consists of carbon in the form of industrial carbon black, graphite, comminuted carbon fibres or carbon nanofibers, more particularly single-wall or multi-wall carbon nanotubes.

**Revendications**

1. Procédé de subdivision pour la subdivision d'un matériau (6) de départ de corps solide en au moins deux pièces (7) partielles de corps solide comprenant les stades suivants :

   a) on se procure le matériau (6) de départ de corps solide ayant au moins une surface à découvert,
   b) on dépose un matériau (1) polymère - hybride sur au moins une surface à découvert du matériau (6) de départ de corps solide, de manière à obtenir une structure composite, le matériau (1) de polymère - hybride comprenant :

      une matrice (2) polymère,
      une première matière (3) de charge, qui est incorporée dans la matrice (2) polymère et qui comprend un métal ou qui est constituée d'un métal, et
      une deuxième matière (4) de charge, qui comprend des particules noyau - coque - polymère,

   c) on soumet la structure composite à un champ de tension, de manière à ce que le matériau (6) de départ de corps solide soit clivé le long d'un plan (9) de détachement au sein du matériau (6) de départ de corps solide en les au moins deux pièces (7) partielles de corps solide,
   d) on élimine le matériau (1) polymère - hybride.

2. Procédé de subdivision suivant la revendication 1,

   dans lequel on dépose d'abord une couche sacrificielle sur la surface à découvert du matériau (6) de départ de corps solide, et
   dans lequel on dépose ensuite le matériau (1) polymère - hybride sur la couche sacrificielle, de manière à ce que la structure composite comprenne le matériau (6) de départ de corps solide, la couche sacrificielle et le matériau (1) polymère - hybride.

3. Procédé de subdivision suivant la revendication 1 ou 2, dans lequel on active, au moyen d'un plasma à basse température, le matériau (1) polymère - hybride et/ou le matériau (6) de départ de corps solide ou la couche sacrificielle avant le dépôt suivant le stade b).

4. Procédé de subdivision suivant l'une des revendications 1 à 3, dans lequel, dans le stade b), on dépose le matériau polymère - hybride comme constituant d'une feuille, au moyen d'un laminage ou d'un collage, sur au moins une surface du matériau (6) de départ de corps solide ou sur la couche sacrificielle.

5. Procédé de subdivision suivant l'une des revendications 1 à 4, dans lequel on produit, dans le matériau (6) de départ de corps solide, des défauts, au moyen d'au moins une source (13) de rayonnement pour la prescription du plan (9) de détachement.

6. Procédé de subdivision suivant l'une des revendications 1 à 5, dans lequel on élimine le matériau (1) polymère - hybride de la pièce (7) partielle de corps solide par au moins l'un de ce qui suit :

   a) traitement par un solvant apolaire, en particulier par un hydrocarbure aliphatique ou aromatique,
   b) traitement séquentiel par un solvant polaire et par un solvant apolaire,
   c) traitement aux ultrasons à résolution spatiale ou traitement par mégasons,
   d) opération dans un rouleau à rouleau.

7. Procédé de subdivision suivant la revendication 6, dans lequel on colle et/ou on lamine à chaud un support auxiliaire temporaire sur le matériau (1) polymère - hybride.

8. Procédé de subdivision suivant l'une des revendications 1 à 7, dans lequel on se procure le matériau (1) polymère - hybride sous la forme d'une feuille.

9. Procédé de subdivision suivant l'une des revendications précédentes,

   dans lequel la première matière (3) de charge est répartie dans la matrice (2) polymère, de manière à ce que la proportion en masse de la première matière (3) de charge diminue à partir d'une surface (24) limite inférieure

du matériau (1) polymère - hybride qui, pendant l'opération de subdivision, est reliée au matériau (6) de départ de corps solide directement ou indirectement par une autre couche, dans la direction d'une autre surface limite, disposée à l'opposé de la surface (24) limite inférieure, du matériau (1) polymère - hybride, désignée dans ce qui suit comme étant la surface (25) limite supérieure, et/ou

dans lequel une partie inférieure du matériau (1) polymère - hybride, qui est voisine directement de la surface (24) limite inférieure, et/ou

dans lequel une partie supérieure du matériau (1) polymère - hybride, qui est voisine directement de la surface (25) limite supérieure, n'a pas de première matière (3) de charge.

**10.** Procédé de subdivision suivant l'une des revendications précédentes,

dans lequel la première matière (3) de charge peut réagir sur un agent de réaction, de préférence un agent d'oxydation, en dégageant un produit gazeux, et/ou

dans lequel la première matière (3) de charge a une conductibilité thermique plus grande que le polymère de la matrice (2) polymère.

**11.** Procédé de subdivision suivant l'une des revendications précédentes,

dans lequel la deuxième matière (4) de charge est répartie dans la matrice (2) polymère, de manière à ce que la proportion en masse de la deuxième matière (4) de charge augmente en direction de la surface (24) limite inférieure, et/ou

dans lequel la deuxième matière (4) de charge peut être activée au moyen d'un plasma à basse température.

**12.** Procédé de subdivision suivant l'une des revendications précédentes, dans lequel le matériau polymère - hybride a en outre :

une troisième matière (5) de charge qui, par rapport au polymère de la matrice (2) polymère, a une conductibilité thermique plus grande et/ou un module d'élasticité plus grand,

dans lequel la troisième matière (5) de charge est répartie dans la matrice (2) polymère, de manière à ce que la proportion en masse de la troisième matière (5) de charge augmente en direction de la surface (25) limite supérieure, et/ou

dans lequel la troisième matière (3, 5) de charge comprend au moins un métal, en particulier de l'aluminium, du fer, du zinc et/ou du cuivre.

**13.** Procédé de subdivision suivant l'une des revendications précédentes, dans lequel la proportion en masse de la matrice (2) polymère représente de 80 % à 99 %, de préférence de 90 % et 99 %, du matériau (1) polymère - hybride.

**14.** Procédé de subdivision suivant l'une des revendications précédentes,
dans lequel le matériau (1) polymère - hybride comprend une autre charge comprenant des fibres minérales ou organiques, des particules à noyau - coque ou de l'acide silicique et/ou dans lequel le matériau (1) polymère - hybride comprend encore une autre matière de charge, qui comprend du carbone sous la forme de suie industrielle, de graphite, de fibres de carbone fragmentées ou de nanofibres de carbone, en particulier de nanotubes de carbone à plusieurs parois ou en est constitué.

## FIG 1A

## FIG 1B

## FIG 1C

FIG 2A

FIG 2B

FIG 2C

EP 3 433 876 B1

FIG 3A

13

18

17

14

9

6

19

FIG 3B

13

14

6

9, 16

20

7

19

FIG 4

19   22   19

9

23

21

**IN DER BESCHREIBUNG AUFGEFÜHRTE DOKUMENTE**

**In der Beschreibung aufgeführte Patentdokumente**

- WO 2009061353 A2
- WO 2010072675 A2
- DE 102012001620 A1
- DE 19640594 A1
- EP 3361495 A1